# EUROPEAN PATENT APPLICATION

(11) **EP 1 124 252 A2**
(43) Date of publication of application: **16.08.2001**
(21) Application number: 01102400.7
(22) Date of filing: 02.02.2001
(51) Int. Cl.: H01L 21/00

(54) **Apparatus and process for processing substrates**

(30) Priority: 10.02.2000 US 502126
(71) Applicant: Applied Materials, Inc., Santa Clara, California 95054 (US)
(72) Inventor: Ponnekanti, Hari, Fremont, California 94538 (US); Fairbairn, Kevin, Los Gatos, California 95032 (US); Somekh, Sasson, Los Altos Hils, California 94022 (US); Weidman, Timothy, Sunnyvale, CA 94086 (US); Shamouilian, Shamouil, San Jose, CA 95120 (US); Moghadam, Farhad, Saratoga, CA 95070 (US)
(74) Representative: Kirschner, Klaus Dieter, Dipl.-Phys.

(57) **Abstract**

The present invention generally provides a process and an apparatus for depositing low dielectric constant films and low dielectric constant capping layers on a substrate. The low dielectric constant films are mesoporous oxide films formed by depositing and curing a sol gel precursor containing a surfactant to form a oxide film having interconnecting pores of uniform diameter, and then annealing the film in an inert gas atmosphere or exposing the film to an oxidizing atmosphere containing a reactive oxygen species to form a mesoporous oxide film. A preferred mesoporous oxide film is produced by spin-on deposition of a sol gel precursor containing TEOS, water, and a surfactant in an alcohol based solvent on a substrate, curing the sol gel precursor to form a cubic phase film, and then exposing the film to an oxidizing atmosphere. The apparatus of the invention provides a cassette to cassette processing system which processes multiple substrates and combines the advantages of an atmosphere processing module for depositing films, such as dielectric films, with an in-situ vacuum capping module for high quality substrate processing, high substrate throughput and reduced contamination of the process.

## Description

The present invention relates generally to a method and apparatus for processing multiple substrates typically used in the fabrication of electronic devices such as integrated circuits and flat panel displays. More particularly, the invention relates to a process and apparatus for depositing dielectric layers on a substrate.

Semiconductor device geometries have dramatically decreased in size since such devices were first introduced several decades ago. Since then, integrated circuits have generally followed the two year/half-size rule (often called Moore's Law), which means that the number of devices that will fit on a chip doubles every two years. Today's fabrication plants are routinely producing devices having 0.35µm and even 0.18µm feature sizes, and tomorrow's plants soon will be producing devices having even smaller geometries.

In order to further reduce the size of devices on integrated circuits, it has become necessary to use conductive materials having low resistivity and insulators having low dielectric constants (k, wherein k < 4.0) to reduce the capacitive coupling between adjacent metal lines. Low k dielectrics have been deposited by both spin-on glass methods and by chemical vapor deposition (CVD) techniques as described in International Publication Number WO 99/41423. Liner/barrier layers including capping layers have been deposited adjacent the low k dielectric layers to prevent diffusion of byproducts such as moisture from the low k dielectric layer onto the conductive material as described in International Publication Number WO 99/41423.

For example, moisture generated during formation of a low k insulator readily diffuses to the surface of the conductive metal and increases the resistivity of adjacent conductive metal surface. The barrier/liner layer is typically formed from conventional silicon based materials, such as silicon nitride, that block the diffusion of byproducts and/or prevent the diffusion of metal layers into the low k material. However, the barrier/liner layers typically have dielectric constants that are significantly greater than 4.0, such as silicon nitride with a dielectric constant of at least 6.0, and the high dielectric constants can result in a combined insulator layer that does not significantly reduce the dielectric constant.

An example of a low k film deposition process is described in US-A-5,858,457 discloses a method for forming a low dielectric constant film having a high porosity on the substrate. The structure is generally formed by the deposition on a substrate of a sol gel precursor followed by selective evaporation of components of the sol gel precursor to form supramolecular assemblies. The assemblies are then formed into ordered porous films by the oxidative pyrolysis of the supra-molecular templates at approximately 400°C. However, in the US-A-5,858,457, the pyrolysis step requires about four hours to calcinate the sol gel into a porous film. Such lengths of time are incompatible with the increasing demand for higher processing speeds in modern semi-conductor manufacturing.

The silica-based films, as described in US-A-5,858,45, are porous films that are often hydrophilic and aggressively absorb moisture from the surrounding environment. If water, which has a dielectric constant (k) of about 78, is absorbed by the porous film, then the low k dielectric properties of the porous film can be detrimentally affected. Often, these hydrophilic films are annealed to remove moisture, but this is only a temporary solution in a deposition process since the films are still sensitive to moisture contamination following this procedure. Additionally, annealing is often a time consuming process which adds to the processing time of the substrate and results in lower through put rates. Generally, to limit moisture contamination in hydrophilic films a capping or passivation layer to prevent moisture contamination is deposited on the porous film or the film is turned from a hydrophilic film to a hydrophobic film by a silylation process.

One problem in depositing capping layers on porous films is that porous films, such as spin-coating and spray-coating porous films are deposited at atmosphere pressure, *i*.*e*., greater than about 300 Torr, and the capping layer is typically deposited by a plasma enhanced chemical vapor deposition (PECVD) process carried out at near vacuum pressures, *i*.*e*., less than about 100 Torr. Such vacuum processes and atmosphere processes are typically carried out in separate vacuum and atmosphere processing systems or cluster tool apparatuses, wherein transfer from one processing system or apparatus to another exposes the porous films to contamination. Cluster tools are modular, multi-chamber, integrated processing system having a central substrate handling module and a number of peripheral process chambers, where introduced substrates undergo a series of process steps sequentially in various process chambers to form integrated circuits. Cluster tools have become generally accepted as effective and efficient equipment for manufacturing advanced microelectronic devices.

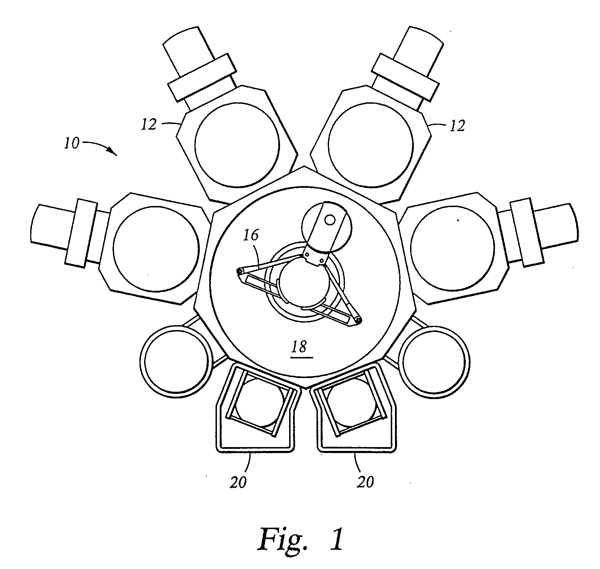

Figure 1 illustrates a vacuum cluster tool 10 having multiple single substrate processing chambers 12 mounted on a centralized vacuum chamber, called a transfer chamber 18, for transferring substrates from a substrate cassette located in one or more load lock chambers 20, to one or more process chambers 12. This particular tool is shown to accommodate up to four (4) single substrate processing chambers 12 positioned radially about the transfer chamber. A cluster tool similar to that shown in Figure 1 is available from Applied Materials, Inc. of Santa Clara, California. The transfer of the substrates between the process chambers 12 is typically managed by a substrate handling module 16 located in a central transfer chamber 12. After the substrates are processed, they are moved back through the load lock chamber 20 and into substrate cassettes where the substrates can be moved to the next system for additional processing. Various processes, such as physical vapor deposition (PVD), chemical vapor deposition (CVD), etch, can be performed in the process chambers 12.

Typically, atmosphere processing cluster tools and vacuum processing cluster tools have not been integrated. Vacuum processing tools require the retention of a vacuum or reestablishment of a vacuum by vacuum pumping during various process steps in a process cycle. This vacuum requirement lends to longer processing times and a lower through-put rate than compared to atmosphere processing tools which has made integration of these systems unattractive. However, transfer of substrates between the cluster tools can result in contamination of the process substrates which is very problematic in the transfer of films sensitive to contamination, such as porous films. Currently in the industry, there are no cluster tools that combine the deposition of low k dielectric materials and capping materials under both ambient atmosphere and near vacuum processing conditions.

Therefore, there remains a need for an integrated atmosphere and vacuum system that can deposit and cap low k dielectric materials with high substrate throughput. Ideally, the integrated system will reduce contamination of deposited materials by eliminating one or more transfers between vacuum cluster tools and atmosphere cluster tools.

The present invention provides a process and apparatus for depositing intermetal layers, such as low dielectric constant (low k) films, and capping layers on a substrate at both vacuum and atmosphere, or high pressure, conditions. In one aspect of the invention, the apparatus is a near vacuum pressure capping layer module capable of being mounted on processing platforms operating at atmospheric or high pressures, which processing platforms may further deposit low k dielectric layers. The capping layer module has a cassette to cassette near vacuum processing system which processes multiple substrates having a low k dielectric layer that is deposited in the attached platform. The capping layer module is preferably a staged vacuum system which includes one or more transfer chambers, each transfer chamber housing a substrate handler, one or more loadlock chambers, one or more substrate preheating modules which optionally may be disposed in the one or more loadlock chambers, and one or more plasma enhanced chemical vapor deposition chambers in communication with the one or more transfer chambers.

The apparatus of the invention may further comprise one or more substrate cooling stations disposed in the loadlock chamber connected to the transfer chamber. The capping module preferably has a substrate handling member with at least one substrate handling blade and further includes a substrate indexing device for indexing multiple substrates and a multi-slot preheating module for preheating substrates prior deposition of the capping layer. Each PECVD chamber preferably has two processing regions, each processing region having a heated pedestal, a gas distribution assembly, vacuum pumping assembly, and independent RF power and temperature controls to provide a uniform plasma density over a substrate surface in each processing region, wherein each processing region is in communication with a remote plasma system and the transfer chamber.

In another aspect of the invention, the apparatus for processing substrates is a near vacuum pressure capping layer module coupled with a high pressure deposition module. The apparatus for processing substrates comprises a high pressure deposition module, a first transfer chamber in communication with the high pressure deposition module, a loadlock chamber in communication with the first transfer chamber, one or more second transfer chambers, each housing a substrate handler and in communication with the one or more loadlock chambers, a multi-slot substrate pre-heating module in communication with the second transfer chamber, and which may optionally be disposed in the one or more loadlock chambers, a substrate handling member disposed in the second transfer chamber, and one or more processing chambers, each processing chamber defining at least one isolated processing region therein, wherein each processing region is connected to the one or more second transfer chambers. The loadlock chambers of the capping module transfer substrates between the first and second transfer chambers and may further provide substrate cooling following processing or substrate pre-heating prior to processing.

The high pressure deposition module is preferably a staged atmosphere system which generally includes a housing containing one or more substrate spinner chambers, one or more substrate curing chambers, one or more substrate stripping chambers (or one or more annealing chambers) which may be evacuated to near vacuum conditions and are compatible with oxygen and/or ozone atmospheres and oxygen containing plasmas, one or more silylation deposition chambers, and a substrate handling member disposed in the housing of the high pressure deposition module. Preferably, there are a plurality of chambers, wherein each type of chamber is mounted in a vertically disposed stack within the chamber. The substrate handling member is generally a two armed substrate handler, preferably with independently moving arms which have access to all of the processing chambers within the high pressure deposition module.

In accordance with another aspect of the invention, the invention provides a process for depositing low K dielectric films having a mesoporous film structure. The low K dielectric films are deposited by curing a sol gel precursor deposited on a substrate to form a oxide film, preferably having interconnecting pores of uniform diameter, most preferably in a cubic phase structure, and then heating the oxide film in a non-reactive atmosphere at a temperature of about 200°C to about 450°C, preferably annealing the oxide film at about 400°C to about 450°C, or exposing the film to an oxidizing atmosphere containing a reactive oxygen species at a temperature between about 200°C and about 400°C, to form a mesoporous oxide film. The mesoporous oxide film will have a porosity of at least 50% and a dielectric constant between about 1.6 and about 2.2. The mesoporous oxide film may be used as a inter-metal layer for fabricating a dual damascene structure. A preferred mesoporous oxide film is produced by spin-on deposition of a sol gel precursor containing TEOS, water, and a surfactant in a ethanol solvent on a substrate, curing the sol gel precursor to form a film having interconnecting pores of uniform diameter, and then exposing the film to an ozone plasma.

According to an aspect of the invention, there is provided an apparatus for processing substrates, comprising one or more transfer chambers; a substrate handling member disposed in each of the one or more transfer chambers; one or more processing chambers, each processing chamber defining at least one isolated processing region therein, wherein each processing region is connected to the one or more transfer chambers; one or more loadlock chambers in communication with the one or more transfer chambers; and one or more multi-slot substrate pre-heating modules in communication with the one or more transfer chambers.

According to an aspect of the invention, there is provided an apparatus for processing substrates, comprising:
(a) a high pressure deposition module;
(b) a first transfer chamber in communication with the high pressure deposition module;
(c) a loadlock chamber in communication with the first transfer chamber;
(d) a second transfer chamber in communication with the loadlock chamber;
(e) a multi-slot substrate pre-heating module in communication with the first transfer chamber;
(f) a substrate handling member disposed in the second transfer chamber; and
(g) one or more processing chambers, each processing chamber defining at least one isolated processing region therein, wherein each processing region is connected to the second transfer chamber.

According to a preferred aspect of the invention, the high pressure deposition module comprises:
(a) one or more substrate spinner chambers;
(b) one or more substrate curing chambers;
(c) one or more substrate stripping chambers;
(d) one or more silylation deposition chambers; and
(e) a second substrate handling member disposed in the high pressure deposition module.

According to a preferred aspect of the invention, the apparatus further comprises a vacuum pump in fluid communication with each processing region in the one or more processing chambers.

According to a preferred aspect of the invention, the apparatus further comprises a remote plasma system having a RF generator connected to each processing region.

According to a preferred aspect of the invention, each substrate stripping chamber is an oxidation chamber.

According to a preferred aspect of the invention, the oxidation chamber and is connected to a remote plasma system having a RF generator or a microwave generator.

According to an aspect of the invention, there is provided a process for forming a mesoporous oxide film on a substrate, comprising:
a) forming a sol gel precursor comprising a silicon/oxygen compound, an organic solvent, water, and a surfactant;
b) depositing the sol gel precursor on the substrate;
c) curing the deposited sol gel precursor to form an oxide film; and
d) exposing the film to an oxidizing environment to form a mesoporous oxide film.

According to a preferred aspect of the invention, the oxidizing environment is a plasma comprising a reactive oxygen species.

According to a preferred aspect of the invention, the reactive oxygen species is ozone.

According to a preferred aspect of the invention, the mesoporous oxide film exhibits a dielectric constant between about 1.6 and about 2.2.

According to a preferred aspect of the invention, the mesoporous oxide film has a porosity of at least 50%.

According to a preferred aspect of the invention, the mesoporous oxide film is cured at a temperature between about 50°C to about 450°C.

According to a preferred aspect of the invention, the mesoporous oxide film is cured between about 1 minute to about 10 minutes.

According to an aspect of the invention, there is provided a process for forming a mesoporous oxide film on a substrate, comprising:
a) introducing a substrate into a chamber;
b) depositing a sol gel precursor on the substrate to form an oxide film, the sol gel precursor comprising a silicon/oxygen compound, an organic solvent, water, and a surfactant; and
c) removing the organic solvent, water, and the surfactant from the oxide film by heating the film at a temperature of about 200°C to about 450°C in an inert atmosphere to form a mesoporous oxide film.

According to a preferred aspect of the invention, the mesoporous oxide film comprises a structure of interconnected pores of uniform diameter.

According to a preferred aspect of the invention, the mesoporous oxide film further comprises a cubic phase structure.

According to a preferred aspect of the invention, the silicon/oxygen compound precursor is selected from the group consisting of tetraethylorthosililate, tetramethoxy silane, phenyltriethyloxy silane, methyltriethoxy silane, and combinations thereof.

According to a preferred aspect of the invention, the organic solvent is selected from the group consisting of ethanol, isopropanol, n-propanol, n-butanol, sec-butanol, t-butanol, ethylene glycol and combinations thereof.

According to a preferred aspect of the invention, the surfactant is a non-ionic surfactant selected from the group consisting of polyoxyethylene oxides-propylene oxide-polyethylene oxide triblock copolymers, octaethylene glycol monodecyl ether, octaethylene glycol monohexadecyl ether, and combinations thereof.

According to a preferred aspect of the invention, the inert atmosphere comprises a non-reactive gas selected from the group consisting of nitrogen, helium, argon, and combinations thereof.

According to a preferred aspect of the invention, the mesoporous oxide film is formed by annealing the oxide film at a temperature between about 400°C to about 450°C.

According to a preferred aspect of the invention, the mesoporous oxide film is annealed for about 30 to about 300 seconds.

According to a preferred aspect of the invention, the mesoporous oxide film exhibits a dielectric constant between about 1.6 and about 2.2.

According to a preferred aspect of the invention, the oxidizing environment is maintained at a temperature between about 200°C to about 400°C.

According to a preferred aspect of the invention, the oxide film is exposed to the oxidizing environment for about 30 to about 300 seconds.

According to a preferred aspect of the invention, the silylation process is performed with a slylating agent selected from the group consisting of tetra-methyl-di-silazane (TMDS), hexamethyl disilazane (HMDS), deimethylaminotrimethyl silane, and combinations thereof.

According to a preferred aspect of the invention, the the silylation process is performed at a temperature between about 25°C to 200°C.

According to a preferred aspect of the invention, the process further comprises depositing a capping layer on the mesoporous oxide film, the capping layer is comprised of materials selected from the group consisting of silicon nitride, silicon dioxide, silicon oxynitride, amorphous silicon carbide, and combinations thereof.

A computer storage medium containing a software routine that, when executed, causes a general purpose computer to control a deposition chamber using a method of any of the preceding claims.

So that the manner in which the above recited features and advantages of the embodiments of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.
- Figure 1: is a top schematic view of a radial cluster tool for batch processing of semiconductor substrates;
- Figure 2A: is a top schematic view of one embodiment of an apparatus containing a capping module and high pressure deposition module of the present invention;
- Figure 2B: is a top schematic view of another embodiment of an apparatus containing a capping module and high pressure deposition module of the present invention;
- Figure 3A: is a top schematic planar view of one embodiment of a capping module of the present invention;
- Figure 3B: is a top schematic view of one embodiment of a capping module of the present invention;
- Figure 4: is a perspective view of an embodiment of a loadlock chamber of the present invention;
- Figure 5: is a top schematic view of a transfer chamber and a processing chamber showing a substrate handling member of the present invention mounted in the transfer chamber and in a retracted position ready for rotation within the transfer chamber or extension into another chamber;
- Figure 6: is a top schematic view of a transfer chamber and a processing chamber showing a substrate handling member of the present invention mounted in the transfer chamber and in an extended position wherein the blades are positioned in the processing chamber;
- Figure 7: is a cross sectional view of a rapid thermal anneal chamber;
- Figure 8: is a perspective view of one embodiment of a PECVD chamber included in the capping module of the present invention;
- Figure 9: is a cross sectional view of the PECVD chamber of the present invention;
- Figure 10: is an exploded view of the gas distribution assembly for the PECVD chamber;
- Figure 11: is a top view of a PECVD chamber of the present invention with the lid removed;
- Figure 12: is an illustrative block diagram of the hierarchical control structure of a computer program for process control;
- Figure 13: is an illustrative view of the mesoporous film process showing cubic-phase structure and mesoporous film structure;
- Figure 14: is a cross sectional view showing a dual damascene structure comprising a low k silicon oxide layer and capping layer of the present invention; and
- Figures 15A-H: are cross sectional views showing a dual damascene deposition sequence of the present inventions.

The present invention provides a process and apparatus for depositing intermetal layers, such as low dielectric constant (low k) films, and capping layers on a substrate at both vacuum, *i*.*e*., less than about 100 Torr, and atmosphere, or high pressure, conditions, *i*.*e*., greater than about 300 Torr. In one aspect of the invention, the apparatus is a near vacuum pressure capping layer module capable of being mounted on processing platforms operating at atmospheric or high pressures, which processing platforms may further deposit low k dielectric layers. The capping layer module has a cassette to cassette near vacuum processing system which processes multiple substrates having a low k dielectric layer that is deposited in the attached platform. The capping layer module is preferably a staged vacuum system which includes one or more transfer chambers each housing a substrate handler, one or more loadlock chambers, one or more multi-slot substrate preheating modules in communication with the one or more transfer chambers and which optionally may be disposed in the one or more loadlock chambers, and one or more plasma enhanced chemical vapor deposition chambers in communication with the one or more transfer chambers. Isolatable means that the processing regions have a confined plasma zone separate from the adjacent region which is selectively communicable with the adjacent region via an exhaust system.

The processing regions within each PECVD chamber also preferably include separate gas distribution assemblies and RF power sources to provide a uniform plasma density over a substrate surface in each processing region. The PECVD chambers are configured to allow multiple, isolated processes to be performed concurrently in at least two regions so that at least two substrates can be processed simultaneously in separate processing regions with a high degree of process control provided by shared gas sources, shared exhaust systems, separate gas distribution assemblies, separate RF power sources, and separate temperature control systems. For ease of description, the terms processing regions a chamber may be used to designate the zone in which plasma processing is carried out.

In another aspect of the invention, the apparatus for processing substrates is a near vacuum pressure capping layer module coupled with a high pressure deposition module. The apparatus for processing substrates comprises a high pressure deposition module, a first transfer chamber in communication with the high pressure deposition module, a loadlock chamber in communication with the first transfer chamber, a second transfer chamber in communication with the loadlock chamber, a multi-slot substrate pre-heating module in communication with the second transfer chamber and which may optionally be disposed in the loadlock chamber, a substrate handling member disposed in the second transfer chamber, and one or more processing chambers, each processing chamber defining at least one isolated processing region therein, wherein each processing region is connected to the second transfer chamber.

The high pressure deposition module is preferably a staged atmosphere system which provides processing apparatus for forming mesoporous films. The processing apparatus include one or more substrate spinner chambers for deposition of a sol gel precursor, one or more substrate curing chambers to remove solvent and moisture to form interconnecting pores of uniform diameter, preferably in a cubic phase structured film, one or more substrate stripping chambers (or annealing chambers) for removing surfactant from the film to produce a mesoporous film, and one or more silylation deposition chambers if the user desires to turn the hydrophilic mesoporous film into a hydrophobic mesoporous film. Preferably, there are a plurality of chambers, wherein each type of chamber is mounted in a vertically disposed stack within the module. The high pressure deposition module further includes a substrate handling member which is generally a dual bladed substrate handler that has access to all of the processing chambers within the housing.

In accordance with one aspect of the invention, the invention provides for an process for depositing an mesoporous oxide layer having a low dielectric constant and a high oxide content. The mesoporous oxide layer comprises a silica material and can be capped in the capping module with other dielectric materials or with an etch stop layer, e.g. for fabricating a dual damascene structure. The low K dielectric layers can be deposited by curing a sol gel precursor to form a oxide film having interconnecting pores of uniform diameter, preferably in a cubic phase structure then exposing the film to an oxidizing atmosphere containing a reactive oxygen species at a temperature between about 200°C and about 400°C, to remove the surfactant and form a mesoporous oxide film. The mesoporous oxide film will have a porosity of at least 50% and a dielectric constant between about 1.6 and about 2.2. The mesoporous film may also be used as a inter-metal dielectric layer. A preferred mesoporous oxide film is produced by spin-on deposition of a sol gel precursor containing tetraethylorthosililate (TEOS), water, and a surfactant in a ethanol solvent on a substrate, curing the sol gel precursor to form interconnecting pores of uniform diameter, preferably in a cubic phase film, and then removing the surfactant by an oxidizing atmosphere.

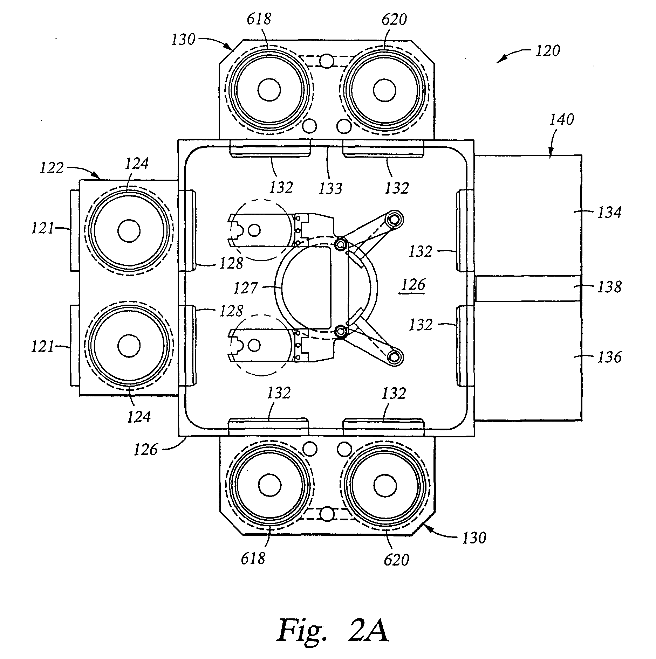

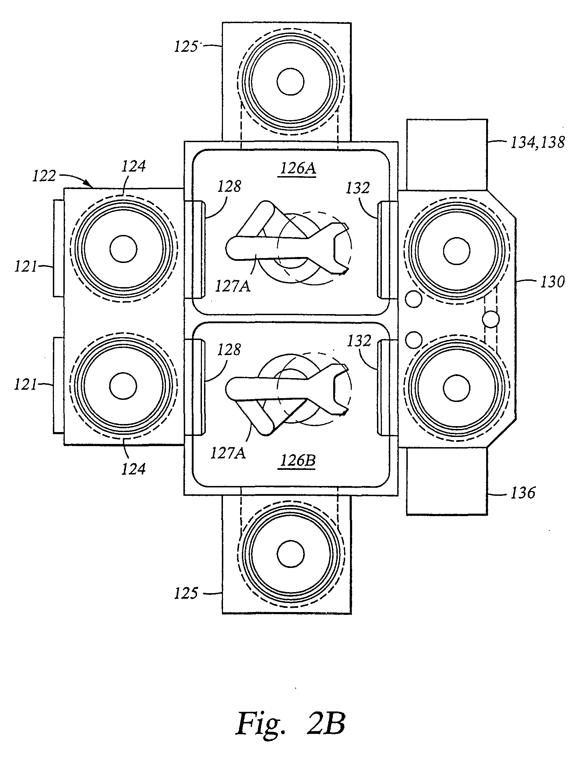

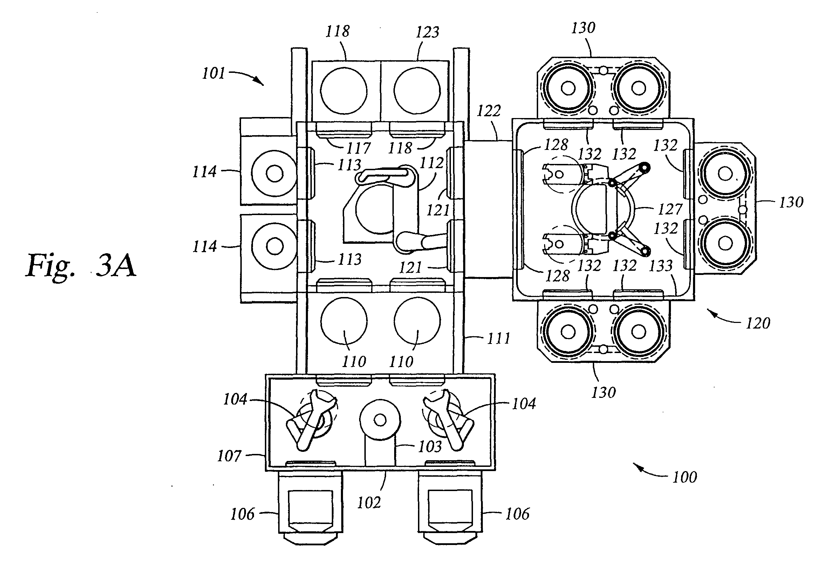

Figures 2A and 3A illustrate one embodiment of a capping layer module 120 of the invention schematically. The capping module 120 is a near vacuum pressure processing module for deposition of films, particularly capping films deposited by plasma enhanced chemical vapor deposition (PECVD). Near vacuum pressures are defined herein as pressures of about 100 Torr and below, and preferably the pressure of the capping module are the similar to the operating pressure of the PECVD chamber of about 0.5 Torr to about 10 Torr. The module 120 is a self-contained system having the necessary processing utilities supported on a main frame structure 201 which can be easily installed and which provides a quick start up for operation. The module 120 generally includes four regions, namely, a factory interface 122, wherein substrates are introduced into the module 120, one or more transfer chambers 126 each housing a substrate handler 127, with the substrate handler 127 preferably in communication with a dual stack cooling/pre-heat loadlock chamber 124 disposed within the factory interface 122, one or more, but preferably two tandem or twin process chambers 130 mounted to the and in communication with the transfer chamber 126, and a back end 140 which houses the support utilities needed for operation of the module 120, such as a gas panel 134, power distribution panel 136, and the computer control rack 138 as shown in Figures 2B and 3D. The system can be adapted to accommodate various processes and supporting chamber hardware such as plasma enhanced chemical vapor deposition (PECVD). The embodiment described below will be directed to a system employing a PECVD process, such as a mesoporous oxide dielectric deposition process. However, it is to be understood that these other processes are contemplated by the present invention.

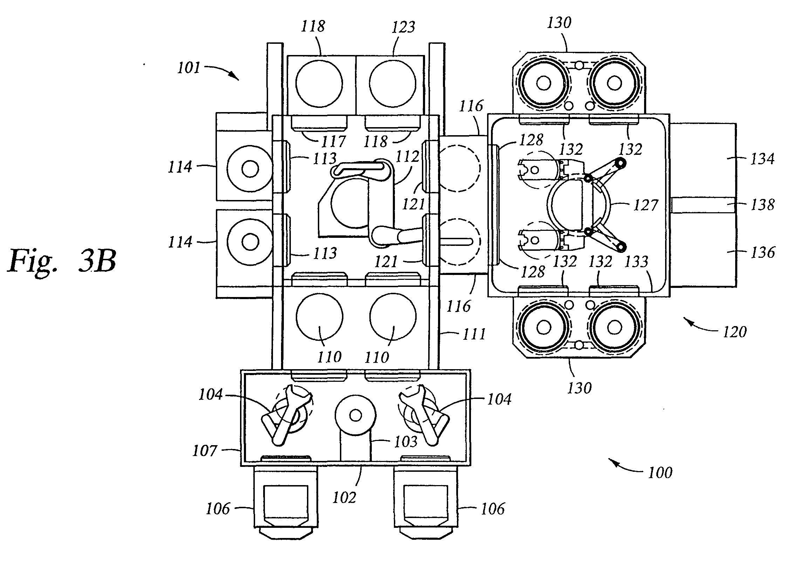

Figures 2B illustrates another embodiment of a capping layer module 120 of the invention schematically. The capping module 120 also comprises four regions, namely, a factory interface 122, wherein substrates are introduced into the module 120, one or more transfer chambers 126A, 126B each housing a substrate handler 127A, 127B with the substrate handlers 127A, 127B preferably in communication with a dual stack cooling loadlock chamber 124 disposed within the factory interface 122 and in communication with a substrate preheating station 125, one or more, but preferably two tandem or twin process chambers 130 mounted to, and in communication with, the transfer chamber 126A, 126B, and a back end 140 which houses the support utilities needed for operation of the module 120, such as a gas panel 134, power distribution panel 136, and the computer control rack 138 as shown in Figure 2B and 3B. The substrate preheating station 125 generally comprises a plurality of vertically disposed substrate holders and provides heating to the substrates. The substrate holder alignment and substrate heating processes are disclosed in more detail below in the description for the pre-heating loadlock chamber 124, however, the invention contemplates other pre-heating stations.

### Transfer Chamber

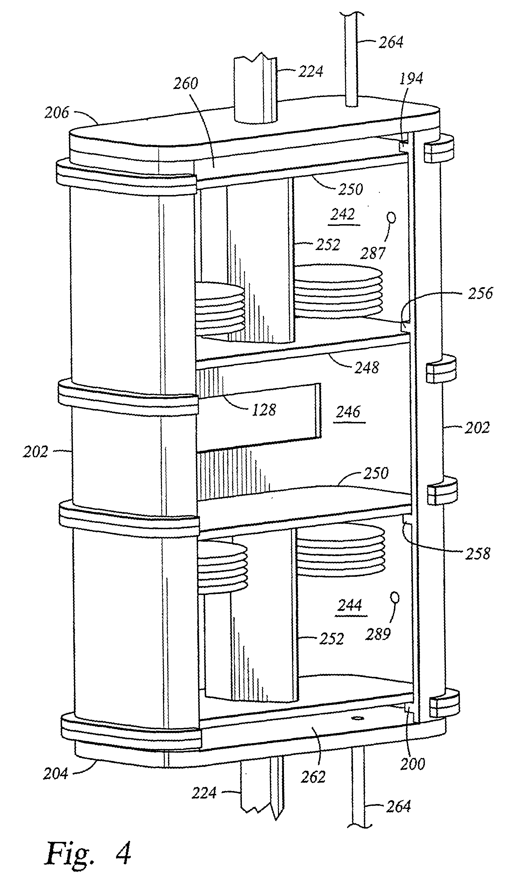

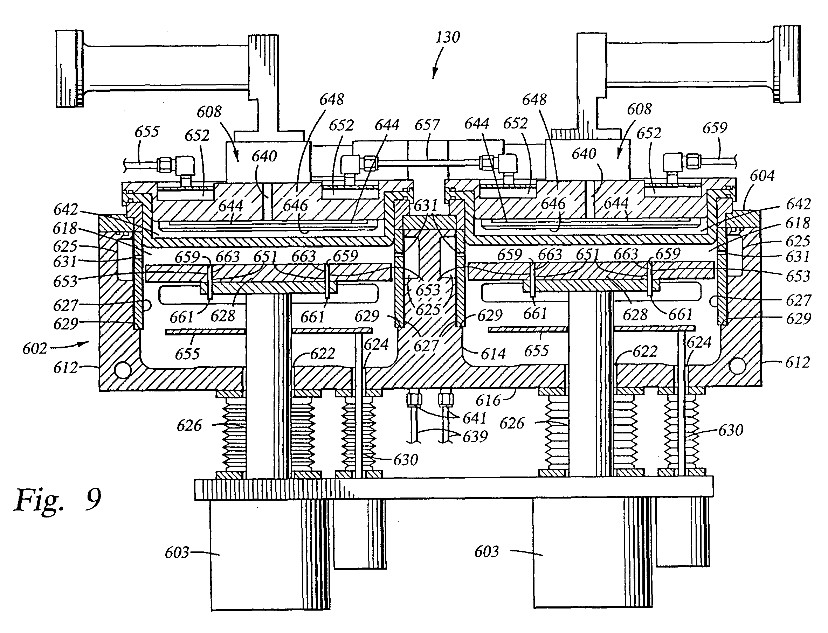

Figure 2A shows a top schematic view of one embodiment of the processing module 120 of the present invention. The processing module 120 encompasses transfer chamber 126 inside a chamber sidewall 133. The transfer chambers include sidewalls 133 and bottom 135 and are preferably machined or otherwise fabricated from one piece of material, such as aluminum. A lid (not shown) for transfer chamber 126 is supported on the sidewalls 133 during operation to form a vacuum enclosure. The sidewall 133 of transfer chamber 126 supports processing chambers 130 and provides an attachment for a factory interface 122 which may contain one or more cooling/pre-heat loadlock chambers 124 (shown in figure 4 below) which may provide access via slit valve 121 to other transfer chambers or act as a substrate insertion point for processing in the processing chambers 130. The sidewall 133 for transfer chamber 126 defines passage 128 and 132 on each side through which access to the other chambers on the system is provided. The passages 128 and 132 disposed through the sidewalls 133 can be opened and closed using two individual slit valves or a tandem slit valve assembly. The passages 128 provide access the factory interface or substrate staging area 122 wherein substrates may be introduced into the transfer chambers 126. The passages 132 mate with the substrate passages 610 in process regions 618, 620 (shown in Figure 9) to allow entry of substrates into the processing regions 618, 620 in processing chamber 130 for positioning on the substrate heater pedestal 628.

The processing chamber 130 and a substrate staging area 122 includes a slit valve opening and a slit valves 128, 132 which enable communication between the processing chamber 130, a substrate staging area 122, and the transfer chamber 126 while also providing vacuum isolation of the environments within each of these chambers to enable a staged vacuum within the system. Slit valves and methods of controlling slit valves are disclosed by *Tepman et al.* in U.S. Patent No. 5,226,632 and by *Lorimer* in U.S. Patent No. 5,363,872, both of which are incorporated herein by reference. The bottom 135 of the transfer chamber 126 defines a central passage (not shown) in which a substrate handler 127, such as a substrate handler assembly, extends and is mounted to the bottom 135 of the transfer chamber 126. A gas purge port (not shown) is disposed through the bottom 135 of the transfer chamber 126 to provide a purge gas during pump down.

Figure 2B shows a top schematic view of another embodiment of the processing module 120 of the present invention. The second embodiment of the processing module 120 comprises two transfer chambers 126A, 126B inside a chamber sidewall 133. The transfer chambers 126A, 126B are isolated from one another and are in communication with both the factory interface 122 which preferably only contains one or more cooling chambers, and one or more pre-heat loadlock chambers 124 disposed perpendicular to the factory interface 112, and one or more processing chambers 130 or one or more processing regions 618, 620. The sidewall 133 for transfer chambers 126A, 126B defines passages 128 and 132 on each side through which access to the other chambers on the system is provided.

### Substrate Handling In The Transfer Chamber of The Capping Module

Referring to Figure 2A, the substrates provided to the capping layer module 120 by the front end staging area 122 are handled by the capping layer module 120 as follows. Once the front end staging area 122 is loaded, the transfer chamber front vacuum doors 128 to the staging area 122 close and the transfer chamber 126 is pumped down to vacuum processing conditions. The transfer chamber 126 is pumped down by the single or two on-board vacuum pumps (not shown) disposed on the capping module 120. After vacuum pumping to a sufficiently low pressure and following substrate preheating in the loadlock 124, preferably in a preheating compartment 244 (as shown in figure 4 below), the pneumatically actuated front vacuum doors 128 of the transfer chamber 126 open simultaneously allowing access between the transfer chambers 126 and the front end staging area 122. The substrate handling member 127 indexes the substrates held in the dual stack cooling/pre-heat loadlock chamber 124 located in the substrate staging area 122. Then, the substrate handling members within the transfer chamber 126, the dual bladed transfer chamber substrate handling member 127, simultaneously retrieve a substrate from each stack of the dual stack cooling/pre-heat loadlock chamber 124 located in the front end staging area 122 and simultaneously transfer the substrates into the processing regions 618, 620 of a twin processing chamber 130 or transfer the respective substrate into individual processing chambers 130 depending upon the capping module's 120 configuration. Alternatively, the substrates may be pre-positioned in front of the slit valves 132 to the processing chamber 130 during the vacuum pump.

Once the substrate is deposited, the transfer chamber substrate handlers 127 withdraw from the processing chamber 130 and the slit valves 132 are closed. The substrate having already been deposited with a dielectric layer in the high pressure deposition module 101 is then deposited with a capping layer by PECVD in the processing chamber 130. After processing is finished, the slit valves 132 are opened and the transfer chamber substrate handler 127 remove the substrates from the processing regions 618, 620 and deposit the substrates in the cooling compartment 242 of the dual stack cooling/pre-heat loadlock chamber 124. After depositing a substrate in the preheating modules 124, the substrate handler retrieves the next pair of substrates from dual stack cooling/pre-heat loadlock chamber 124 indicated in the indexing sequence. This substrate is then transferred, processed, and retrieved by the transfer chamber substrate handler 127 as the preceding substrate. This process continues until all of the substrates of the pre-heating compartment 244 are processed in the PECVD processing chamber 130 and deposited in the cooling compartment 244. After the last substrate is processed the slit valves 132 to the processing chamber 130 are closed.

The transfer chamber 126 is then vented to atmosphere pressure using an inert gas, such as argon, and the front vacuum doors 128 are opened. The transfer chamber venting may optionally begin as soon as the slit valves 132 have closed after the last pair of substrates have been processed. This allows the transfer chamber 126 to be vented as the last set of substrates are being returned to the dual stack cooling/pre-heat loadlock chamber 124 which reduces processing time in the capping module 120. Once venting is complete, the transfer chamber substrate handler 112 of the high pressure deposition module 101 retrieve the substrates from the dual stack cooling/pre-heat loadlock chamber 124 and simultaneously unload all of the processed substrates to the substrate cassettes 104 located in the front end staging area 102 of the high pressure deposition module 101.

After the last pair of substrates in each batch have been processed and removed from the processing chamber 130 and the slit valves 132 have been closed, the process chamber cleaning process can occur preparing the processing chamber for the next batch of substrates. This enables the cleaning process to be ongoing in the background while the transfer chamber 126 is being vented and the substrates are being exchanged.

### High Pressure Deposition Module

Referring back to Figure 3A, another embodiment of the invention the capping layer module 120 is coupled with a high pressure deposition module 101 via a substrate staging area 122. The high pressure deposition module 101 preferably deposits dielectric materials, such as mesoporous oxide films discussed below, and is often referred to as the high pressure deposition module. The high pressure deposition module 101 is a near atmosphere pressure processing module for deposition of films, where high pressure, or near atmospheric pressure, is defined herein as pressures of about 300 Torr and greater, and preferably at pressure of greater than 500 Torr.

The coupled capping layer module 120 and high pressure deposition module 101 form the processing system 100 of the present invention. The substrate staging area 122 uses the dual stack cooling/pre-heat loadlock chamber 124 to transfer substrates between the capping layer module 120 and the high pressure deposition module 101. The high pressure deposition module 101 is preferably a staged atmosphere system which includes one or more substrate spinner chambers 114 with respective slit valves 113, one or more substrate curing chambers 116 with respective slit valves 115, one or more substrate stripping chambers 118 with respective slit valves 117, one or more silylation deposition chambers 123 with respective slit valves 119, dual stack cooling stations 110 in cooling station 111, and a substrate handling member 112 disposed in the transfer chamber 108 of the high pressure deposition module 101. Preferably, there are at least one of each spinner 114, curing 116, stripping 118, and silylation 123 chambers, wherein each type of chamber is mounted in a vertically spaced stack within the transfer chamber 108 of the high pressure deposition module 101.

As shown in Figure 3B, the chambers, such as the one or more substrate curing chambers 116 may be mounted on or in loadlock 124 for efficient conservation of space. The substrate handling member 112 is generally a two armed substrate handler 112, preferably having two arms with independent rotational movement, with each arm capable of accessing the various chambers within the transfer chamber 108 of the module 101. Alternatively, the two aimed substrate handler 112 may have tandem moving arms and preferably of the same model as the substrate handler 127 of the capping layer module 120.

The front end staging area 102 of the high pressure deposition module 101 of the processing system 100 typically has one or more substrate cassettes 106 mounted in a horizontally spaced relationship from one another on a staging platform 102 which is coupled to the transfer chamber 108 of the high pressure deposition module 101. The substrate cassettes 106 are adapted to support a plurality of substrates mounted in a spaced vertical arrangement. The substrate cassettes 106 preferably includes two or more cassette plates (not shown) or other substrate supports disposed in a spaced vertical relationship to support the substrates disposed therein in a stacked vertical arrangement. A substrate rest 103 may be disposed between the dual stack cooling stations 110 in cooling station 111 and the loadlocks 106 to provide a cooling rest for substrates during substrate exchange between the cooling station 111 and the loadlocks 106. Alternatively, the substrate rest 103 may provide a preheating station for substrates passing into the module 101 for processing.

A pair of substrate handlers, or staging substrate handlers 104, are disposed in the front end staging area 102. The staging substrate handlers 104 are adapted to load a substrate into and remove a substrate from the high pressure deposition module 101 or the substrate cassettes 106 of the high pressure deposition module 101, wherein the staging substrate handler 104 is preferably positioned between the substrate cassettes 106 and the dual stack cooling stations 110 of the high pressure deposition module 101. Preferably, the staging substrate handler 104 includes a substrate indexing system to index the substrates in each substrate cassette 106 in preparation for loading the substrates into high pressure deposition module 101. One substrate handler with a substrate mapping system used advantageously in the present system is available from Equippe Technologies, located in Sunnyvale, California, as Model Nos. ATM 105 or 107. The substrate mapping sensor verifies the number of substrates and orientation of the substrates in the cassette 106 before transferring the substrates into the transfer chamber 108 of the high pressure deposition module 101 for dielectric layer deposition.

The high pressure deposition module 101 shown in Figure 3A contains two vertically stacked dual substrate spinner chambers 114, two columns of four vertically stacked substrate curing chambers 116, four twin vertically stacked substrate stripping chambers 118 and silylation deposition chambers 123. All of the vertically stacked chambers face a substrate handler 112 disposed centrally to chambers 114, 116, 118, 123.

### Substrate Handling In The High Pressure Deposition Module

The dielectric substrate handling process begins with the staging substrate handlers 104 indexing the substrates in each substrate cassette 106. Once indexed, the substrates are transferred by the staging substrate handlers 104 to the dual stack cooling stations 110 in cooling station 111. The high pressure deposition module substrate handler 112 retrieves a substrate from the dual stack cooling stations 110 and transfers the substrate to the dielectric substrate spinner chamber 114 for deposition of a sol gel precursor layer. The module substrate handler 112 may fill up the substrate spinner chamber 114 before processing occurs or may be programmed for multiple spinner chambers to deposit substrates in the substrate spinner modules 114 while one or more spinner modules 114 are processing a substrate. Once the sol gel precursor has been deposited, the module substrate handler 112 retrieves the substrate and transfers the substrate to a curing or baking chamber 116. Due to the relative length of curing compared to other process step in the dielectric layer deposition sequence, a proportionately larger number of curing chambers 116, preferably about 8 curing chambers per two dual substrate spinner chamber 114, are located within the transfer chamber 108 of the module 101. The module substrate handler 112 may be programmed to fill up the curing chambers 116 with spin-on deposited substrates prior to processing or may be programmed to load and unload substrates in the curing chambers 116 as desired. After, the desired amount of curing has been achieved, the substrate is transferred to a substrate stripping chamber 118. The substrate is placed within the ozone stripper for removal of surfactant remaining in the cured sol gel precursor. While, not shown, an optional anneal chamber may be disposed in the transfer chamber 108 of the module 101 for annealing the substrate to remove moisture, solvents, or surfactants from the substrate to either prepare the substrate for the ozone strip or provide an alternative method of forming the mesoporous film besides by ozone stripping. If the deposited dielectric film is to be silylated, the substrate is then retrieved from the substrate stripping chamber 118 and transferred to the silylation chamber 123. Alternatively, for a capping layer to be deposited, the substrate is transferred to the substrate staging area 122 for the capping layer module 120. Once processed by either the silylation chamber 123 or the capping module 120, the substrate handler 112 retrieves the substrate and transfers the substrate to the substrate cassettes 106 via the dual stack cooling stations 110.

### Front End Staging Area

Referring back to Figures 2 and 3, the factory interface or substrate staging area 122 is an atmosphere pressure apparatus which allows quick transfer from the substrate staging area to chambers, such as the high pressure deposition module 101 prior to vacuum pumping, that typically operate at or near atmosphere pressures. Figure 3A shows the front end staging area 102 of the module 101 which preferably includes a dual stack cooling/pre-heat loadlock chamber 124 having one or more substrate cassettes mounted within the dual stack cooling/pre-heat loadlock chamber 124 for processing. The substrate cassettes are designed to support a plurality of substrates in a spaced vertical relation, wherein substrate handling members 112, 127 may deposit and retrieve the substrates from opposites side of the substrate cassettes. In the alternative embodiment shown in Figure 2A, the loadlock chamber 124 also functions as a cooling station for substrate transport between modules 101 and 120, and the pre-heating performed in a separate chamber.

Substrates housed in the cooling/pre-heat loadlock chamber 124 prior to or after processing are loaded into the module 120 through one or more transfer chamber doors 128 (shown in Figure 2A) disposed through transfer chamber sidewall 133. A substrate handler 127 in the transfer chamber 126 is located adjacent to cooling/pre-heat loadlock chamber 124 and the transfer chamber doors 128. Preferably, the substrate handler 127 includes a substrate mapping system to index the substrates in each substrate cassette in preparation for loading and unloading the substrates into the processing chambers 130 mounted to the transfer chamber 126.

The substrate handler 127 can enter the load lock chamber 124 at the same time as another substrate handler 112 (shown in Figure 3A) since the load lock is at atmosphere for transferring the substrates to the load lock chamber 124 from the high pressure deposition module 101. The opening in the side 128 of the transfer chamber 126 will have been closed prior to vacuum pumping of the transfer chamber 126 which is done prior to transferring the substrates into the processing chamber 130 for deposition of a capping layer.

### Dual Position Loadlock Chamber

Figure 4 shows a cut-away perspective view of a cooling/pre-heat loadlock chamber 124 of the present invention. The cooling/pre-heat loadlock chamber 124 includes chamber walls 202, a bottom 204, and a lid 206. The chamber 124 includes two separate environments or compartments 242, 244 and a transfer region 246. Compartments 242, 244 include a substrate cassette in each compartment 242, 244 to support the substrates therein. Each compartment 242, 244 includes a support platform 248 and a top platform 250 to define the bottom and top of the compartments 242, 244. A support wall 252 may be disposed vertically within the compartments 242, 244 to support platforms 248, 250 in a spaced relationship. Transfer region 246 includes one or more passages 121 for providing access from the cooling/pre-heat loadlock chamber 124 into the transfer chambers 108, 126. Passages 121 are preferably opened and closed using slit valves and slit valve actuators.

Compartment 242 provides a cooling station for substrates following processing in the processing chambers of transfer chamber 108 or in the capping module 120. In the alternative embodiment shown in Figure 2A, both compartments 242, 244 may provide cooling stations for substrates following processing in the processing chambers of transfer chamber 108 or in the capping module 120.

Compartment 244 is selectively heated with respect to compartment 242, thereby acting as a pre-heat module prior to processing of the substrates in the processing chambers 130 of the capping module 120. The heating compartment 244 preferably has a heating element, such as a heating lamp, fluid heat exchanger, or a resistive heating element, to heat substrates individually therein, or alternatively, may have a heating element for heating all substrates within the compartment 244 concurrently. In another embodiment of the loadlock 124, the curing modules 116 may be mounted in the pre-heating compartment 244, thereby providing curing of the deposited film or pre-heating of the substrate prior to processing in module 120 while efficiently conserving space.

Compartments 242, 244 are each connected to an elevator shaft 224, each of which is connected to a motor, such as a stepper motor or the like, to move the compartments upwardly or downwardly within the cooling/pre-heat loadlock chamber 124. A sealing flange 256 is disposed peripherally within the cooling/pre-heat loadlock chamber 124 to provide a sealing surface for support platform 248 of compartment 242. Sealing flange 258 is similarly disposed to provide a sealing surface for support platform 250 of compartment 244. The compartments 242, 244 are isolated from one another by sealing flanges 256, 258 to provide independent staged vacuum of the compartments 242, 244 within the cooling/pre-heat loadlock chamber 124.

A back side pressure is maintained in spaces 260, 262 through a vacuum port disposed therein. A vacuum pump is connected to the spaces 260, 262 via exhaust lines 264 so that a high vacuum can be provided in the spaces 260, 262 to assist in sealing the platforms 248, 250 against the sealing flanges 256, 258.

In operation, compartments 242, 244 can be loaded or unloaded in the position shown in Figure 4. Loading doors and actuators (not shown), are provided through the front wall (not shown) at the upper and lower limits of the cooling/pre-heat loadlock chamber 124 corresponding with compartments 242, 244. The pressure in a selected compartment is pumped down after substrates have been loaded into the compartment via exhaust lines 287, 289 and the selected compartment is moved into the transfer region 246. Compartments 242, 244 move independently into the transfer region 246 by the stepper motor. The advantage of having upper and lower compartments 242, 244 is that processing of one set of substrates can occur while a second set of substrates is loaded into the other compartment and that compartment is pumped down to the appropriate pressure so that the compartment can be moved into the transfer region 246 and in communication with the transfer chambers 108, 126.

### Transfer Chamber Substrate Handler

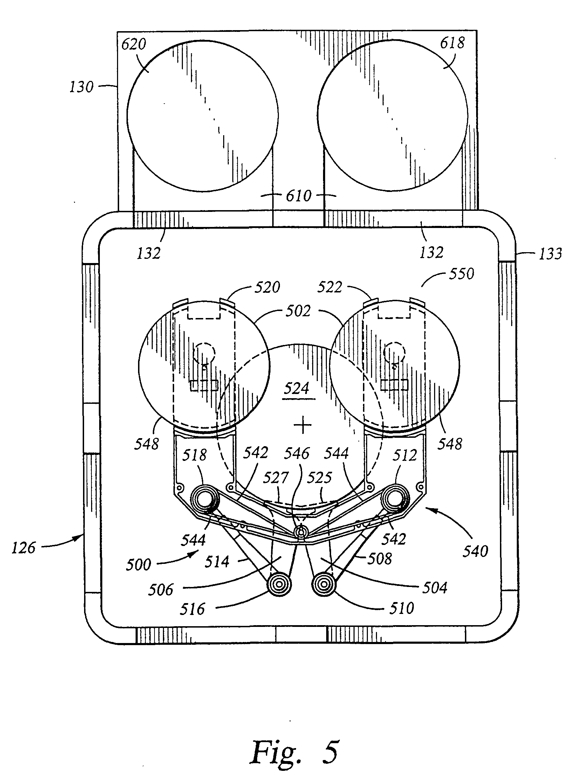

Figure 5 shows a top schematic view of one embodiment of a magnetically coupled substrate handler 500 of the present invention in a retracted position for rotating freely within the transfer chamber 126 (and alternatively in the transfer chamber 108, described in detail above). A substrate handler having dual substrate handling blades 520, 522 is located within the transfer chamber 126 to transfer the substrates 502 from one chamber to another. A "very high productivity" (VHP) type substrate handler which can be modified and used to advantage in the present invention is the subject of U.S. Patent No. 5,469,035 issued on Nov. 21, 1995, entitled "Two-axis Magnetically Coupled Substrate handler", and is incorporated herein by reference.

The magnetically coupled substrate handler 500 comprises a frog-leg type assembly connected between two vacuum side hubs (also referred to as magnetic clamps) and dual substrate blades 520, 522 to provide both radial and rotational movement of the substrate handler blades within a fixed plane. Radial and rotational movements can be coordinated or combined in order to pickup, transfer, and deliver two substrates from one location within the system 100 to another, such as from one processing chamber 130, to another chamber, such as the loadlock 124. In the embodiment shown in Figure 2B, a single armed robot is disposed in transfer chambers 126A, 126B.

The substrate handler includes a first strut 504 rigidly attached to a first magnet clamp 524 at point 525 and a second strut 506 rigidly attached to a second magnet clamp 526 (disposed concentrically below the first magnet clamp 524) at point 527. A third strut 508 is attached by a pivot 510 to strut 504 and by a pivot 512 to the substrate blade assembly 540. A fourth strut 514 is attached by a pivot 516 to strut 506 and by a pivot 518 to the substrate blade assembly 540. The structure of struts 504, 508, 506, 514 and pivots 510, 512, 516, 518 form a "frog leg" type connection between the substrate blade assembly 540 and the magnet clamps 524, 526.

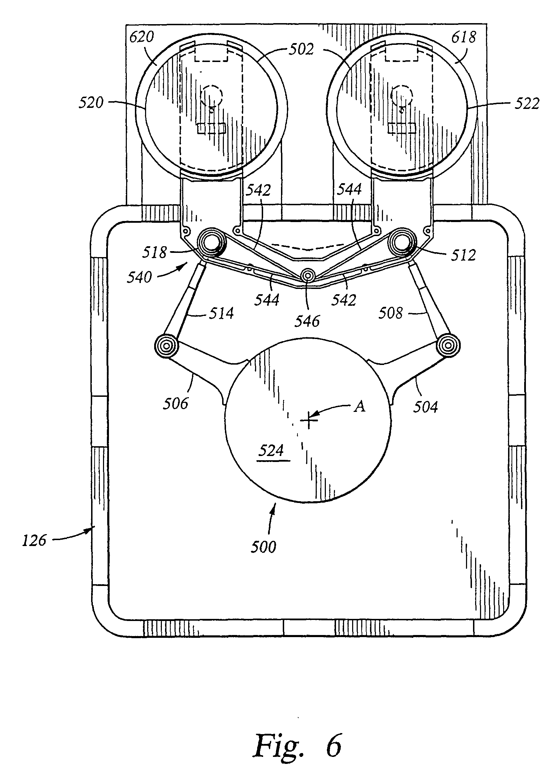

When magnet clamps 524, 526 rotate in the same direction with the same angular velocity, then substrate handler 500 also rotates about axis A in this same direction with the same velocity. When magnet clamps 524, 526 rotate in opposite directions with the same absolute angular velocity, then there is no rotation of assembly 500, but instead, there is linear radial movement of substrate blade assembly 540 to a position illustrated in Figure 6.

Two substrates 502 are shown loaded on the substrate blade assembly 540 to illustrate that the individual substrate blades 520, 522 can be extended through individual substrate passages 132 in sidewall 133 of the transfer chamber 126 to transfer the substrates 502 into or out of the processing regions 618, 620 of the chambers 130. The magnetically coupled substrate handler 500 is controlled by the relative rotational motion of the magnet clamps 524, 526 corresponding to the relative speed of two motors. A first operational mode is provided in which both motors cause the magnet clamps 524, 526 to rotate in the same direction at the same speed. Because this mode causes no relative motion of the magnet clamps, the substrate handler will merely rotate about a central axis A, typically from a position suitable for substrate exchange with one pair of processing regions 618, 620 to a position suitable for substrate exchange with another pair of processing regions.

Furthermore, as the fully retracted substrate handler is rotated about the central axis A, the outermost radial points 548 along the edge of the substrate define a minimum circular region 550 required to rotate the substrate handler. The magnetically coupled substrate handler also provides a second mode in which both motors cause the magnet clamps 524, 526 to rotate in opposite directions at the same speed. This second mode is used to extend the substrate blades 520, 522 of the substrate blade assembly 540 through the passages 132 and into the processing regions 618, 620 or, conversely, to withdraw the blades therefrom. Other combinations of motor rotation can be used to provide simultaneous extension or retraction of the substrate blade assembly 540 as the substrate handler 500 is being rotated about axis A.

To keep the substrate blades 520, 522 of the substrate blade assembly 540 directed radially away from the rotational axis A, an interlocking mechanism is used between the pivots or cams 512, 518 to assure an equal and opposite angular rotation of each pivot. The interlocking mechanism may take on many designs, including intermeshed gears or straps pulled around the pivots in a figure-8 pattern or the equivalent. One preferred interlocking mechanism is a pair of metal straps 542 and 544 that are coupled to and extend between the pivots 512, 518 of the substrate blade assembly 540. The straps 542, 544 connect the pivots 512, 518. It is preferred that the straps 542, 544 be individually adjustable and positioned one above the other. In Figures 5 and 6, the straps are also shown passing around a rod 546 at the base of the U-shaped dual blade. When a dual bladed tandem substrate handler is used in transfer chamber 126, the above described substrate handler is preferably utilized.

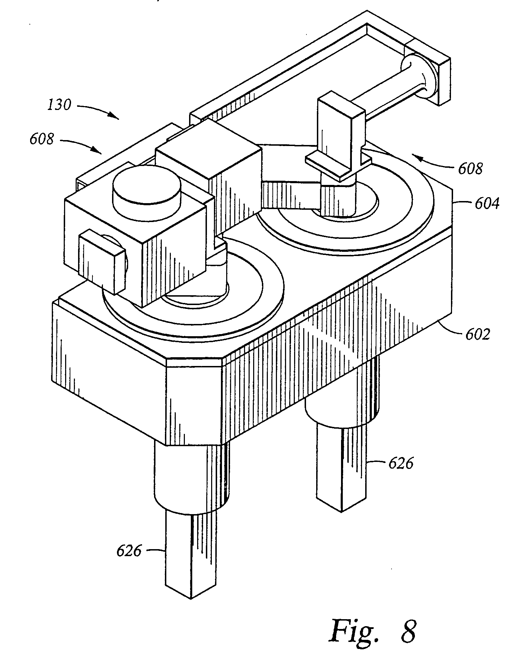

Figure 6 shows the substrate handler arms and blade assembly of Figure 5 in an extended position. This extension is accomplished by the simultaneous and equal rotation of magnet clamp 526 in a clock-wise direction and magnet clamp 524 in a counter-clockwise rotation. The individual blades 520, 522 of the substrate blade assembly 540 are sufficiently long to extend through the passages 132 and center the substrates 502 over the pedestals 628 (See Figure 8). Once the substrates 502 have been lifted from the blades by a pair of lift pin assemblies, then the blades are retracted and the passages 132 are closed by a slit valve and actuator as described above.

### Stripping Chamber

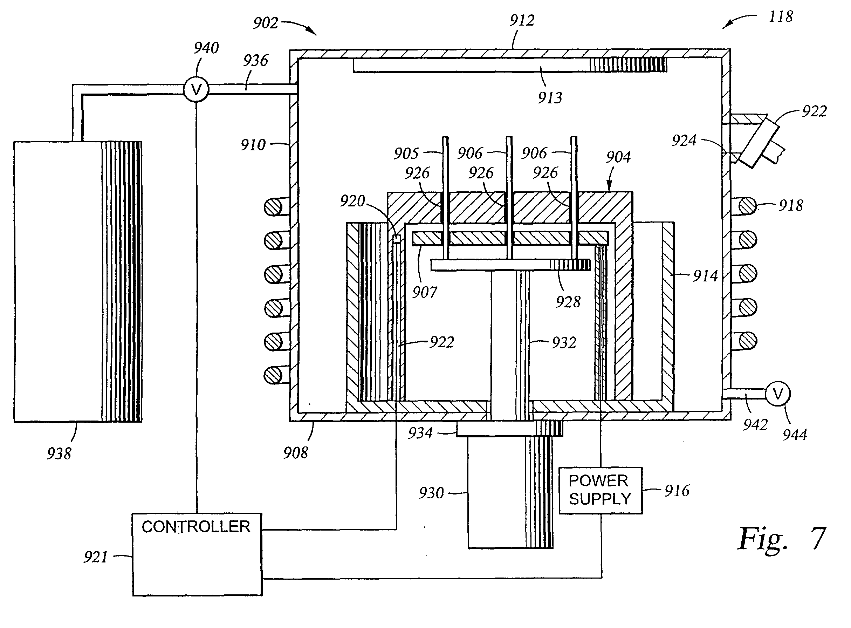

Figure 7 is a cross sectional view of an exemplary substrate stripping chamber of the invention. More particularly, Figure 7 is a rapid thermal anneal chamber that is capable of both a non-reactive gas anneal and an oxidizing gas strip of a deposited film. The substrate stripping chamber or rapid thermal anneal (RTA) chamber 118 is preferably connected to the transfer chamber 108. The high pressure deposition module 101, as shown in Figures 2 and 3, preferably comprises two RTA chambers 118 preferably disposed on opposing sides of the transfer chamber 108 from the capping module 120, with the substrates are transferred into and out of the RTA chamber 118 by the substrate handler 112.

Thermal anneal process chambers are generally well known in the art, and rapid thermal anneal chambers are typically utilized in substrate processing systems to modify the properties of the deposited materials. According to the invention, the annealing chambers 118, are used to perform as a surfactant strip by a high temperature anneal in the presence of a reactant gas or an oxidation of the exposed film to remove the surfactant. One particular thermal anneal chamber useful for the present invention is the WxZ chamber available from Applied Materials, Inc., located in Santa Clara, California. Although the invention is described using a hot plate rapid thermal anneal chamber, the invention contemplates application of other thermal anneal chambers suitable for carrying out the processes of the invention.

The RTA chamber 118 generally comprises an enclosure 902, a heater plate 904, a heater 907 and a plurality of substrate support pins 906. The enclosure 902 includes a base 908, a sidewall 910 and a top 912. Preferably, a cold plate 913 is disposed below the top 912 of the enclosure. Alternatively, the cold plate is integrally formed as part of the top 912 of the enclosure. Preferably, a reflector insulator dish 914 is disposed inside the enclosure 902 on the base 908. The reflector insulator dish 914 is typically made from a material such as quartz, alumina, or other material that can withstand high temperatures (*i*.*e*., greater than about 500°C), and act as a thermal insulator between the heater 907 and the enclosure 902. The dish 914 may also be coated with a reflective material, such as gold, to direct heat back to the heater plate 906.

The heater plate 904 preferably has a large mass compared to the substrate being processed in the system and is preferably fabricated from a material such as silicon carbide, quartz, or other materials that do not react with any ambient gases in the RTA chamber 118 or with the substrate material. The heater 907 typically comprises a resistive heating element or a conductive/radiant heat source and is disposed between the heated plate 906 and the reflector insulator dish 914. The heater 907 is connected to a power source 916 which supplies the energy needed to heat the heater 907. Preferably, a thermocouple 920 is disposed in a conduit 922, disposed through the base 908 and dish 914, and extends into the heater plate 904. The thermocouple 920 is connected to a controller 921 and supplies temperature measurements to the controller 921. The controller 921 then increases or decreases the heat supplied by the heater 907 according to the temperature measurements and the desired anneal temperature. The enclosure 902 preferably includes a cooling member 918 disposed outside of the enclosure 902 in thermal contact with the sidewall 910 to cool the enclosure 902. Alternatively, one or more cooling channels (not shown) are formed within the sidewall 910 to control the temperature of the enclosure 902. The cold plate 913 disposed on the inside surface of the top 912 cools a substrate that is positioned in close proximity to the cold plate 913.

The RTA chamber 118 includes a slit valve 922 disposed on the sidewall 910 of the enclosure 902 for facilitating transfers of substrates into and out of the RTA chamber 118. The slit valve 922 selectively seals an opening 924 on the sidewall 910 of the enclosure that communicates with the transfer chamber 108. The substrate handler 112 transfers substrates into and out of the RTA chamber through the opening 924.

The substrate support pins 906 preferably comprise distally tapered members constructed from quartz, aluminum oxide, silicon carbide, or other high temperature resistant materials. Each substrate support pin 906 is disposed within a tubular conduit 926, preferably made of a heat and oxidation resistant material, that extends through the heater plate 904. The substrate support pins 906 are connected to a lift plate 928 for moving the substrate support pins 906 in a uniform manner. The lift plate 928 is attached to an actuator 930, such as a stepper motor, through a lift shaft 932 that moves the lift plate 928 to facilitate positioning of a substrate at various vertical positions within the RTA chamber. The lift shaft 932 extends through the base 908 of the enclosure 902 and is sealed by a sealing flange 934 disposed around the shaft.

To transfer a substrate into the RTA chamber 118, the slit valve 922 is opened, and the loading station transfer substrate handler 228 extends its substrate handler blade having a substrate positioned thereon through the opening 924 into the RTA chamber. The substrate handler blade of the loading station transfer substrate handler 228 positions the substrate in the RTA chamber above the heater plate 904, and the substrate support pins 906 are extended upwards to lift the substrate above the substrate handler blade. The substrate handler blade then retracts out of the RTA chamber, and the slit valve 922 closes the opening. The substrate support pins 906 are then retracted to lower the substrate to a desired distance from the heater plate 904. Optionally, the substrate support pins 906 may retract fully to place the substrate in direct contact with the heater plate.

Preferably, a gas inlet 936 is disposed through the sidewall 910 of the enclosure 902 to allow selected gas flow into the RTA chamber 118 during the anneal treatment process. The gas inlet 936 is connected to a gas source 938 through a valve 940 for controlling the flow of the gas into the RTA chamber 118. The gas source 938 can provide a non-reactive gas for high temperature annealing or can be a remote unit providing an oxidizing gas, preferably a ozone plasma, to the annealing chamber 118 for oxidation of an exposed substrate film. A gas outlet 942 is preferably disposed at a lower portion of the sidewall 910 of the enclosure 902 to exhaust the gases in the RTA chamber and is preferably connected to a relief/check valve 944 to prevent backstreaming of atmosphere from outside of the chamber. Optionally, the gas outlet 942 is connected to a vacuum pump (not shown) to exhaust the RTA chamber to a desired vacuum level during an anneal treatment.

According to the invention, a substrate is annealed in the RTA chamber 118 after the deposition of an oxide film. Preferably, for a high temperature non-reactive gas anneal, the RTA chamber 118 is maintained at about atmospheric pressure, and the oxygen content inside the RTA chamber 118 is controlled to less than about 100 ppm during the anneal treatment process. Preferably, the ambient environment inside the RTA chamber 118 comprises nitrogen (N₂) or a combination of nitrogen (N₂) and less than about 4% hydrogen (H₂), and the ambient gas flow into the RTA chamber 118 is maintained at greater than 20 liters/min to control the oxygen content to less than 100 ppm. The substrate is annealed at a temperature between about 200°C and about 450°C for between about 30 seconds and 30 minutes, and more preferably, between about 400°C and about 450°C for between about 30 seconds and 5 minutes. Rapid thermal anneal processing typically requires a temperature increase of at least 50°C per second. To provide the required rate of temperature increase for the substrate during the anneal treatment, the heater plate is preferably maintained at between about 350°C and about 450°C, and the substrate is preferably positioned at between about 0 mm (*i*.*e*., contacting the heater plate) and about 20 mm from the heater plate for the duration of the anneal treatment process.

For an oxidation strip of the substrate, the RTA chamber 118 is maintained at about a pressure from about 1 Torr to about 10 Torr, with the oxidation gases composing oxygen or ozone at high temperatures, or an oxygen containing plasma. Preferably, the oxidation is preferably performed on substrate surfaces containing materials that are not sensitive to or reactive with oxygen. Preferably, the oxidizing gas flow into the RTA chamber 118 is maintained at a high flow rate, such as greater than (20) liters/min, to provide for a thorough oxygen strip of the exposed film on the substrate. During the oxygen strip process, the substrate is heated to a temperature between about 200°C and about 450°C for between about 30 seconds and 30 minutes, and more preferably, between about 350°C and about 400°C for between about 30 seconds and 5 minutes. The oxidizing gas is received from an oxygen source (not shown) that may also treat the gas to provide oxygen species from a remote plasma generator RF or a remote microwave generator (not shown).

After the stripping process is completed, the substrate support pins 906 lift the substrate to a position for transfer out of the RTA chamber 118. The slit valve 922 opens, and the substrate handler 112 of the transfer chamber 108 is extended into the RTA chamber and positioned below the substrate. The substrate support pins 906 retract to lower the substrate onto the substrate handler blade, and the substrate handler blade then retracts out of the RTA chamber.

### Process Chambers

Figure 8 shows a perspective view of one embodiment of a tandem processing chamber 130. Chamber body 602 is mounted or otherwise connected to the transfer chamber 126 and includes two processing regions in which individual substrates are concurrently processed. The chamber body 602 supports a lid 604 which is hindgedly attached to the chamber body 602 and includes one or more gas distribution systems 608 disposed therethrough for delivering reactant and cleaning gases into multiple processing regions.

Figure 9 shows a schematic cross-sectional view of the chamber 126 defining two processing regions 618, 620. Chamber body 602 includes sidewall 612, interior wall 614 and bottom wall 616 which define the two processing regions 618, 620. The bottom wall 616 in each processing region 618, 620 defines at least two passages 622, 624 through which a stem 626 of a pedestal heater 628 and a rod 630 of a substrate lift pin assembly are disposed, respectively. A pedestal lift assembly and the substrate lift will be described in detail below.

The sidewall 612 and the interior wall 614 define two cylindrical annular processing regions 618, 620. A circumferential pumping channel 625 is formed in the chamber walls defining the cylindrical processing regions 618, 620 for exhausting gases from the processing regions 618, 620 and controlling the pressure within each region 618, 620. A chamber liner or insert 627, preferably made of ceramic or the like, is disposed in each processing region 618, 620 to define the lateral boundary of each processing region and to protect the chamber walls 612, 614 from the corrosive processing environment and to maintain an electrically isolated plasma environment between the electrodes. The liner 627 is supported in the chamber on a ledge 629 formed in the walls 612, 614 of each processing region 618, 620. The liner includes a plurality of exhaust ports 631, or circumferential slots, disposed therethrough and in communication with the pumping channel 625 formed in the chamber walls. Preferably, there are about twenty four ports 631 disposed through each liner 627 which are spaced apart by about 15° and located about the periphery of the processing regions 618, 620. While twenty four ports are preferred, any number can be employed to achieve the desired pumping rate and uniformity. In addition to the number of ports, the height of the ports relative to the face plate of the gas distribution system is controlled to provide an optimal gas flow pattern over the substrate during processing.

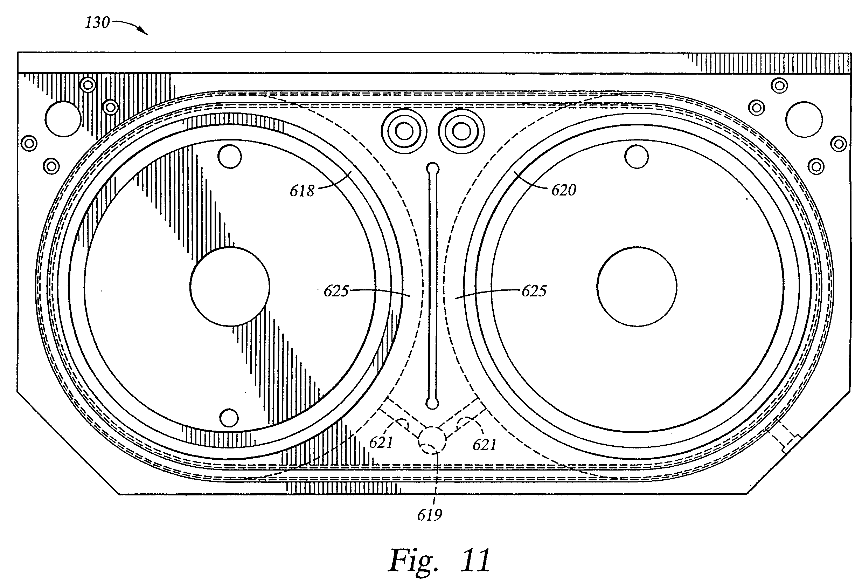

Figure 11 shows a cross sectional view of the chamber illustrating the exhaust system of the present invention. The pumping channels 625 of each processing region 618, 620 are preferably connected to a common exhaust pump via a common exhaust channel 619. The exhaust channel 619 is connected to the pumping channel 625 of each region 618, 620 by exhaust conduits 621. The exhaust channel 619 is connected to an exhaust pump (not shown) via an exhaust line (not shown). Each region is preferably pumped down to a selected pressure by the pump and the connected exhaust system allows equalization of the pressure within each region. The pump is preferably a high vacuum turbo pump capable of providing milliTorr pressures with very low vibration. One vacuum source used to advantage is available from Edward High Vacuum.

Referring back to Figure 9, each of the processing regions 618, 620 also preferably include a gas distribution assembly 608 disposed through the chamber lid 604 to deliver gases into the processing regions 618, 620, preferably from the same gas source. The gas distribution system 608 of each processing region includes a gas inlet passage 640 which delivers gas into a shower head assembly 642. The shower head assembly 642 is comprised of an annular base plate 648 having a blocker plate 644 disposed intermediate a face plate 646. An RF feedthrough provides a bias potential to the showerhead assembly to facilitate generation of a plasma between the face plate 646 of the showerhead assembly and the heater pedestal 628. A cooling channel 652 is formed in a base plate 648 of each gas distribution system 608 to cool the plate during operation. An inlet 655 delivers a coolant fluid, such as water or the like, into the channels 652 which are connected to each other by coolant line 657. The cooling fluid exits the channel through a coolant outlet 659. Alternatively, the cooling fluid is circulated through the manifold.

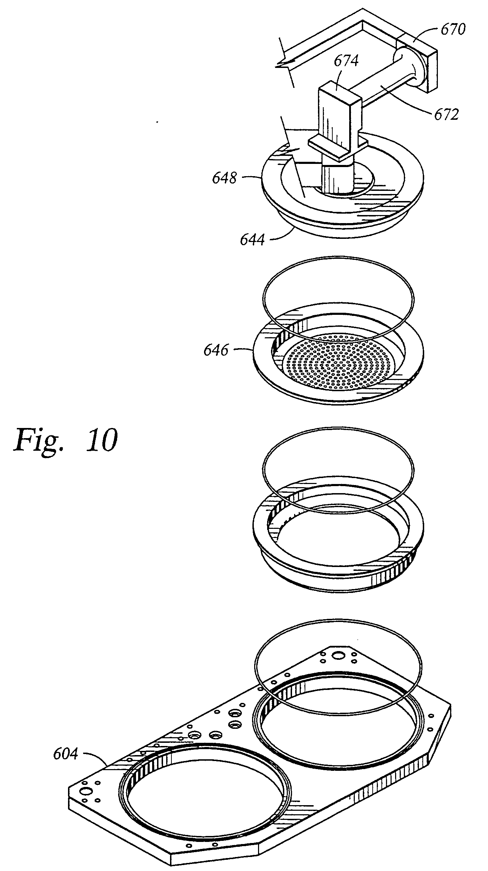

The chamber body 602 defines a plurality of vertical gas passages for each reactant gas and cleaning gas suitable for the selected process to be delivered in the chamber through the gas distribution system. Gas inlet connections 641 are disposed at the bottom of the chamber 126 to connect the gas passages formed in the chamber wall to the gas inlet lines 639. An o-ring is provided around each gas passage formed through the chamber wall on the upper surface of the chamber wall to provide sealing connection with the lid as shown in Figure 11. The lid includes matching passages to deliver the gas from the lower portion of the chamber wall into a gas inlet manifold 670 positioned on top of the chamber lid as shown in Figure 10. The reactant gases are delivered through a voltage gradient feed-through 672 and into a gas outlet manifold 674 which is connected to a gas distribution assembly.

The gas input manifold 670 channels process gases from the chamber gas feedthroughs into the constant voltage gradient gas feedthroughs, which are grounded. Gas feed tubes (not shown) deliver or route the process gases through the voltage gradient gas feedthroughs 672 and into the outlet manifold 674. Resistive sleeves surround the gas feed tubes to cause a linear voltage drop across the feedthrough preventing a plasma in the chamber from moving up the gas feed tubes. The gas feed tubes are preferably made of quartz and the sleeves are preferably made of a composite ceramic. The gas feed tubes are disposed within an isolating block which contains coolant channels to control temperature and prevent heat radiation and also to prevent liquefaction of process gases. Preferably, the insulating block is made of Delrin™ acetal resin. The quartz feed tubes deliver gas into a gas output manifold 674 which channels the process gases to the blocker plate 644 and into the gas distribution plate 646.

The gas input manifold 670 (see Figure 10) also defines a passage which delivers cleaning gases from a chamber gas feedthrough into the remote plasma source (not shown). These gases bypass the voltage gradient feedthroughs and are fed into a remote plasma source where the gases are activated into various excited species. The excited species are then delivered to the gas distribution plate at a point just below the blocker plate through a conduit disposed in gas inlet passage 640.

The gas lines 639 which provide gas into the gas distribution systems of each processing region are preferably connected to a single gas source line and are therefore shared or commonly controlled for delivery of gas to each processing region 618, 620. The gas line(s) feeding the process gases to the multi-zone chamber are split to feed the multiple process regions by a t-type coupling. To facilitate flow into the individual lines feeding each process region, a filter, such as a sintered nickel filter, is disposed in the gas line upstream from the splitter. The filter enhances the even distribution and flow of gases into the separate gas feed lines.

The gas distribution system comprises a base plate 648 having a blocker plate 644 disposed adjacent to its lower surface. A face plate 646 is disposed below the blocker plate 644 to deliver the gases into the processing regions 618, 620. In one embodiment, the base plate 648 defines a gas passage therethrough to deliver process gases to a region just above the blocker plate 644. The blocker plate 644 disperses the process gases over its upper surface and delivers the gases above the face plate 646. The holes in the blocker plate 644 can be sized and positioned to enhance mixing of the process gases and distribution over the face plate 646. The gases delivered to the face plate 646 are then delivered into the processing regions 618, 620 in a uniform manner over a substrate positioned for processing.

A gas feed tube (not shown) is positioned in the gas passage and is connected at one end to an output line from a remote plasma source. One end of the gas feed tube extends through the gas outlet manifold to deliver gases from the remote plasma source. The other end of the gas feed tube is disposed through the blocker plate 644 to deliver gases beyond the blocker plate 644 to the region just above the face plate 646. The face plate 646 disperses the gases delivered through the gas feed tube and then delivers the gases into the processing regions.

While this is a preferred gas distribution system, the gases from the remote plasma source can be introduced into the processing regions 618, 620 through a port (not shown) provided through the chamber wall. In addition, process gases could be delivered through any gas distribution system which is presently available, such as the gas distribution system available from Applied Materials, Inc. of Santa Clara, California.

### Heater Pedestal

Figure 9 shows a heater pedestal 628 which is movably disposed in each processing region 618, 620 by a stem 626 which is connected to the underside of a support plate and extends through the bottom of the chamber body 602 where it is connected to a drive system 603. The stem 626 is preferably a circular, tubular, aluminum member, having an upper end disposed in supporting contact with the underside of the heater pedestal 628 and a lower end closed off with a cover plate. The lower end of the stem is received in a cup shaped sleeve, which forms the connection of the stem to the drive system. The stem 626 mechanically positions the heater pedestal 628 within the processing region and also forms an ambient passageway through which a plurality of heater plate connections can extend. Each heater pedestal 628 may include heating elements to heat a substrate positioned thereon to a desired process temperature. The heating elements may include for example a resistive heating element. Alternatively, the heater pedestal may be heated by an outside heating element such as a lamp. A pedestal used to advantage in the present invention is available from Applied Materials, Inc., of Santa Clara, California. The pedestal may also support an electrostatic chuck, a vacuum chuck or other chucking device to secure a substrate thereon during processing.

The heater pedestal 628 is raised and lowered by moving the transfer housing up or down to a process, clean, lift and release position by a drive system 603 having linear electric actuators (not shown). The transfer housing is connected to the actuator on one side and a linear slide (not shown) on the other through a carriage plate (not shown). The connection between the actuator and the carriage is made via a flexible (ball and socket) joint (not shown) to allow for any misalignment. The linear slide and carriage plate are biased against one another to prevent rotation and bending thereof. A bellows surrounds the stem 626 of the heater pedestal 628 and connects to the chamber bottom 616 on one end and to the transfer housing on the other end. A seal ring (not shown is provided in a groove 630 in the stem 626 to seal the outer surface of the lower end of the stem in the sleeve 624. Leveling of the heater pedestal 628 with respect to the faceplate 646 is achieved with the use of three screws.

Alternatively, the drive system 603 includes a motor and reduction gearing assembly (not shown) suspended below the chamber 130 and connected to a drive belt to a conformable coupling and lead screw assembly. A transfer housing is received on the lead screw assembly, which is guided up and down and held against rotation by a linear slide. The heater lift mechanism is held against the chamber 130 with the drive collar. The heater pedestal 628 is raised and lowered by a lead screw which is driven by a stepper motor. The stepper motor is mounted to the heater lift assembly by a motor bracket. The stepper motor drives the lead screw in a bellows. The bellows turn the lead screw to raise or lower the heater assembly to the process, lift and release positions. A seal ring is provided in a groove in the stem 626 to seal the outer surface of the lower end of the stem 626 in the sleeve.

### Substrate Positioning Assembly

Referring to Figures 8 and 9, the stem 626 moves upwardly and downwardly in the chamber to move the heater pedestal 628 to position a substrate thereon or remove a substrate therefrom for processing. A substrate positioning assembly includes a plurality of support pins 651 which move vertically with respect to the heater pedestal 628 and are received in bores 653 disposed vertically through the pedestal. Each pin 651 includes a cylindrical shaft 659 terminating in a lower spherical portion 661 and an upper truncated conical head 663 formed as an outward extension of the shaft. The bores 653 in the heater pedestal 628 include an upper, countersunk portion sized to receive the conical head 663 therein such that when the pin 651 is fully received into the heater pedestal 628, the head does not extend above the surface of the heater pedestal.

The lift pins 651 move partially in conjunction with, and partially independent of, the heater pedestal 628 as the pedestal moves within the processing region. The lift pins can extend above the pedestal 628 to allow the substrate handler blade to remove the substrate from the processing region, but must also sink into the pedestal to locate the substrate on the upper surface of the pedestal for processing. To move the pins 651, the substrate positioning assembly includes an annular pin support 655 which is configured to engage lower spherical portions 661 of the lift pins 651 and a drive member which positions the pin support 655 to selectively engage the lift pins 651 depending on the position of the heater pedestal 628 within the processing region. The pin support 655, preferably made from ceramic, extends around the stem 626 below the heater pedestal 628 to selectively engage the lower spherical portions of the support pins.

A drive assembly lifts and lowers the shaft 630 and connected pin support 655 to move the pins 651 upwardly and downwardly in each processing region 618, 620. The pin drive member is preferably located on the bottom of the chamber 130 to control the movement of the pin support platform 655 with respect to the pedestal heater 628.

### Gas Box and Supply

Referring to Figures 2 and 3, on the outside of the chamber on the back end of the system, there is a gas supply panel 219 containing the gases that are to be used during deposition and cleaning. The particular gases that are used depend upon the materials to be deposited onto the substrate or removed from the chamber 130. The process gases flow through an inlet port into the gas manifold and then into the chamber through a shower head type gas distribution assembly. An electronically operated valve and flow control mechanism control the flow of gases from the gas supply into the chamber.

In one embodiment of the invention the precursor gases are delivered from the gas box 219 to the chamber 130 where the gas line tees into two separate gas lines which feed gases through the chamber body as described above. Depending on the process, any number of gases can be delivered in this manner and can be mixed either before they are delivered to the bottom of the chamber or once they have entered the gas distribution plate.

### Power Supplies

Referring to Figures 2 and 3, an advanced compact RF ("CRF") power delivery system 136 is used for each processing region 618, 620 with one system connected to each gas distribution system 219. A 13.56 MHz RF generator, Genesis Series, manufactured by ENI, is mounted on the back end of the system for each chamber. This high frequency generator is designed for use with a fixed match and regulates the power delivered to the load, eliminating the concern about forward and reflected power. To interface a high frequency RF generator and a low frequency RF generator to a process chamber, a low pass filter is designed into the fixed match enclosure.

A 350 kHz RF generator manufactured by ENI, is located in an RF generator rack on the back end of the system and linked to the fixed RF match by coaxial cable. The low frequency RF generator provides both low frequency generation and fixed match elements in one compact enclosure. The low frequency RF generator regulates the power delivered to the load reducing the concern about forward and reflected power.

### Programming

The system controller 138 shown in Figures 2 and 3 operates under the control of a computer program stored on the hard disk drive of a computer. The computer program dictates the process sequencing and timing, mixture of gases, chamber pressures, RF power levels, susceptor positioning, slit valve opening and closing, substrate heating and other parameters of a particular process. The interface between a user and the system controller is preferably via a CRT monitor and lightpen (not shown). In a preferred embodiment two monitors are used, one monitor mounted in the clean room wall for the operators and the other monitor behind the wall for the service technicians. Both monitors simultaneously display the same information but only one lightpen is enabled. The lightpen detects light emitted by the CRT display with a light sensor in the tip of the pen. To select a particular screen or function, the operator touches a designated area of the display screen and pushes the button on the pen. The display screen generally confirms communication between the lightpen and the touched area by changing its appearance, i.e. highlight or color, or displaying a new menu or screen.

A variety of processes can be implemented using a computer program product that runs on, for example, the system controller 138. The computer program code can be written in any conventional computer readable programming language such as for example 68000 assembly language, C, C++, or Pascal. Suitable program code is entered into a single file, or multiple files, using a conventional text editor, and stored or embodied in a computer usable medium, such as a memory system of the computer. If the entered code text is in a high level language, the code is compiled, and the resultant compiler code is then linked with an object code of precompiled library routines. To execute the linked compiled object code, the system user invokes the object code, causing the computer system to load the code in memory, from which the CPU reads and executes the code to perform the tasks identified in the program.

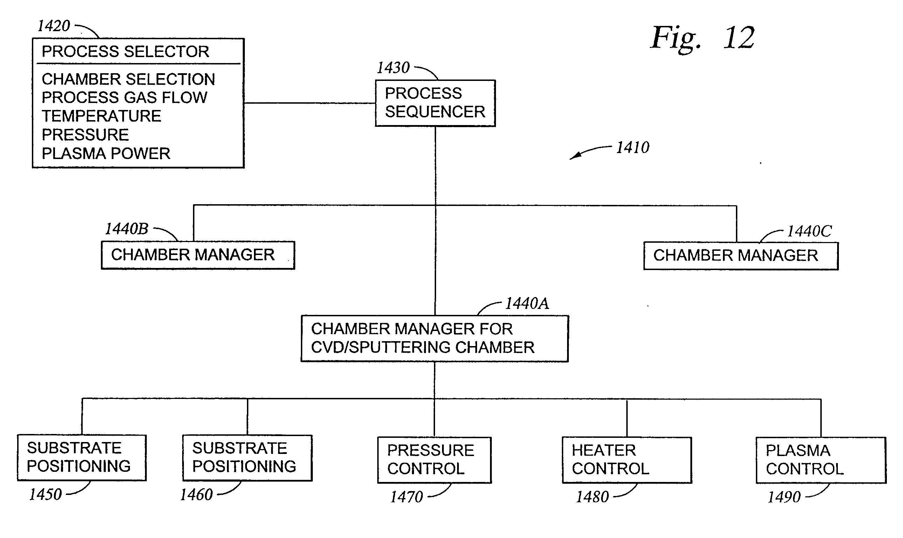

Figure 12 shows an illustrative block diagram of a preferred hierarchical control structure of the computer program 1410. A user enters a process set number and process chamber number into a process selector subroutine 1420 in response to menus or screens displayed on the CRT monitor by using the lightpen interface. The process sets provide predetermined sets of process parameters necessary to carry out specified processes, and are identified by predefined set numbers. The process selector subroutine 1420 identifies (i) the desired process chamber, and (ii) the desired set of process parameters needed to operate the process chamber for performing the desired process. The process parameters for performing a specific process relate to process conditions such as, for example, process gas composition and flow rates, temperature, pressure, plasma conditions such as RF bias power levels and magnetic field power levels, cooling gas pressure, and chamber wall temperature and are provided to the user in the form of a recipe. The parameters specified by the recipe are entered in any conventional manner, but most preferably by utilizing the lightpen/CRT monitor interface.

Electronic signals provided by various instruments and devices for monitoring the process are provided to the computer through the analog input and digital input boards of the system controller. Any conventional method of monitoring the process chambers can be used, such as polling. Furthermore, electronic signals for operating various process controllers or devices are output through the analog output and digital output boards of the system controller. The quantity, type and installation of these monitoring and controlling devices may vary from one system to the next according to the particular end use of the system and the degree of process control desired. The specification or selection of particular devices, such as the optimal type of thermocouple for a particular application, is known by persons with skill in the art.

A process sequencer subroutine 1430 comprises program code for accepting the identified process chamber number and set of process parameters from the process selector subroutine 1420, and for controlling operation of the various process chambers. Multiple users can enter process set numbers and process chamber numbers, or a user can enter multiple process chamber numbers, so the sequencer subroutine 1430 operates to schedule the selected processes in the desired sequence. Preferably, the process sequencer subroutine 1430 includes program code to perform the steps of (i) monitoring the operation of the process chambers to determine if the chambers are being used, (ii) determining what processes are being carried out in the chambers being used. and (iii) executing the desired process based on availability of a process chamber and type of process to be carried out. When scheduling which process is to be executed, the sequencer subroutine 1430 can be designed to take into consideration the present condition of the process chamber being used in comparison with the desired process conditions for a selected process, or the "age" of each particular user entered request, or any other relevant factor a system programmer desires to include for determining the scheduling priorities.

Once the sequencer subroutine 1430 determines which process chamber and process set combination is going to be executed next, the sequencer subroutine 1430 causes execution of the process set by passing the particular process set parameters to a chamber manager subroutine 1440a-c which controls multiple processing tasks in a process chamber 130 according to the process set determined by the sequencer subroutine 1430. For example, the chamber manager subroutine 1440a comprises program code for controlling sputtering and CVD process operations in the process chamber 130. The chamber manager subroutine 1440 also controls execution of various chamber component subroutines which control operation of the chamber component necessary to carry out the selected process set. Examples of chamber component subroutines are substrate positioning subroutine 1450, process gas control subroutine 1460, pressure control subroutine 1470, heater control subroutine 1480, and plasma control subroutine 1490. Those having ordinary skill in the art will recognize that other chamber control subroutines can be included depending on what processes are desired to be performed in the process chamber 130. In operation, the chamber manager subroutine 1440a selectively schedules or calls the process component subroutines in accordance with the particular process set being executed. The chamber manager subroutine 1440a schedules the process component subroutines similarly to how the sequencer subroutine 1430 schedules which process chamber 130 and process set is to be executed next. Typically, the chamber manager subroutine 1440a includes steps of monitoring the various chamber components, determining which components need to be operated based on the process parameters for the process set to be executed, and causing execution of a chamber component subroutine responsive to the monitoring and determining steps.

Operation of particular chamber components subroutines will now be described with reference to Figure 12. The substrate positioning subroutine 1450 comprises program code for controlling chamber components that are used to load the substrate onto the pedestal 628, and optionally to lift the substrate to a desired height in the chamber 130 to control the spacing between the substrate and the showerhead 642. When substrates are loaded into the chamber 130, the pedestal 628 is lowered and the lift pin assembly is raised to receive the substrate and, thereafter, the pedestal 628 is raised to the desired height in the chamber, for example to maintain the substrate at a first distance or spacing from the gas distribution manifold during the CVD process. In operation, the substrate positioning subroutine 1450 controls movement of the lift assembly and pedestal 628 in response to process set parameters related to the support height that are transferred from the chamber manager subroutine 1440a.

The process gas control subroutine 1460 has program code for controlling process gas composition and flow rates. The process gas control subroutine 1460 controls the open/close position of the safety shut-off valves, and also ramps up/down the mass flow controllers to obtain a desired gas flow rate. The process gas control subroutine 1460 is invoked by the chamber manager subroutine 1440a, as are all chamber components subroutines, and receives from the chamber manager subroutine process parameters related to the desired gas flow rate. Typically, the process gas control subroutine 1460 operates by opening a single control valve between the gas source and the chamber 130 gas supply lines, and repeatedly (i) measuring the mass flow rate, (ii) comparing the actual flow rate to the desired flow rate received from the chamber manager subroutine 1440a, and (iii) adjusting the flow rate of the main gas supply line as necessary. Furthermore, the process gas control subroutine 1460 includes steps for monitoring the gas flow rate for an unsafe rate, and activating a safety shut-off valve when an unsafe condition is detected.

In some processes, an inert gas such as argon is provided into the chamber 130 to stabilize the pressure in the chamber before reactive process gases are introduced into the chamber. For these processes, the process gas control subroutine 1460 is programmed to include steps for flowing the inert gas into the chamber 130 for an amount of time necessary to stabilize the pressure in the chamber, and then the steps described above would be carried out. Additionally, when a process gas is to be vaporized from a liquid precursor, for example tetraethylorthosilane (TEOS), the process control subroutine 1460 would be written to include steps for bubbling a delivery gas such as helium through the liquid precursor in a bubbler assembly. For this type of process, the process gas control subroutine 1460 regulates the flow of the delivery gas, the pressure in the bubbler, and the bubbler temperature in order to obtain the desired process gas flow rates. As discussed above, the desired process gas flow rates are transferred to the process gas control subroutine 1460 as process parameters. Furthermore, the process gas control subroutine 1460 includes steps for obtaining the necessary delivery gas flow rate, bubbler pressure, and bubbler temperature for the desired process gas flow rate by accessing a stored data table containing the necessary values for a given process gas flow rate. Once the necessary values are obtained, the delivery gas flow rate, bubbler pressure and bubbler temperature are monitored, compared to the necessary values and adjusted accordingly.

The pressure control subroutine 1470 comprises program code for controlling the pressure in the chamber 130 by regulating the size of the opening of the throttle valve in the exhaust system of the chamber. The size of the opening of the throttle valve is varied to control the chamber pressure at a desired level in relation to the total process gas flow, the gas-containing volume of the process chamber, and the pumping set point pressure for the exhaust system. When the pressure control subroutine 1470 is invoked, the desired set point pressure level is received as a parameter from the chamber manager subroutine 1440a. The pressure control subroutine 1470 operates to measure the pressure in the chamber 130 using one or more conventional pressure manometers connected to the chamber, compare the measured value(s) to the set point pressure, obtain PID (proportional, integral, and differential) control parameters from a stored pressure table corresponding to the set point pressure, and adjust the throttle valve according to the PID values obtained from the pressure table. Alternatively, the pressure control subroutine 1470 can be written to open or close the throttle valve to a particular opening size to regulate the chamber 130 to the desired pressure.

The heater control subroutine 1480 comprises program code for controlling the temperature of the lamp or heater module that is used to heat the substrate. The heater control subroutine 1480 is also invoked by the chamber manager subroutine 1440a and receives a desired, or set point, temperature parameter. The heater control subroutine 1480 determines the temperature by measuring voltage output of a thermocouple located in a pedestal 628, compares the measured temperature to the set point temperature, and increases or decreases current applied to the heater to obtain the set point temperature. The temperature is obtained from the measured voltage by looking up the corresponding temperature in a stored conversion table, or by calculating the temperature using a fourth order polynomial. When radiant lamps are used to heat the pedestal 628, the heater control subroutine 1480 gradually controls a ramp up/down of current applied to the lamp. The gradual ramp up/down increases the life and reliability of the lamp. Additionally, a built-in-fail-safe mode can be included to detect process safety compliance, and can shut down operation of the lamp or heater module if the process chamber 130 is not properly set up. The plasma control subroutine 1490 comprises program code for setting the RF bias voltage power level applied to the process electrodes in the chamber 130, and optionally, to set the level of the magnetic field generated in the chamber. Similar to the previously described chamber component subroutines, the plasma control subroutine 1490 is invoked by the chamber manager subroutine 1440a.

While the system of the present invention was described above with reference to a plasma enhanced CVD application, it is to be understood that the invention also includes the use of high density (HDP) CVD and PVD chambers as well as etch chambers. For example, the system of the present invention can be adapted to include tandem HDP CVD chambers for plasma processing. In one alternative embodiment, the gas distribution/lid assembly could be replaced with a dielectric dome having an inductive coil disposed about the dome and an RF power supply connected to the coil to enable inductive coupling of a high density plasma within the chamber. Similarly, tandem PVD chambers could be configured with a target assembly disposed thereon for a deposition material source. DC power supplies could be connected the target assemblies to provide sputtering power thereto.

### Mesoporous Oxide Films

While the following process descriptions apply to the use of the dielectric deposition module to deposit mesoporous oxide films and the capping module to deposit silicon dioxide, silicon nitride, silicon oxynitride, and amorphous silicon carbide, BLOk™, films, the invention contemplates the deposition of other materials which may be used with the processes performed in the dielectric deposition module and the capping module.

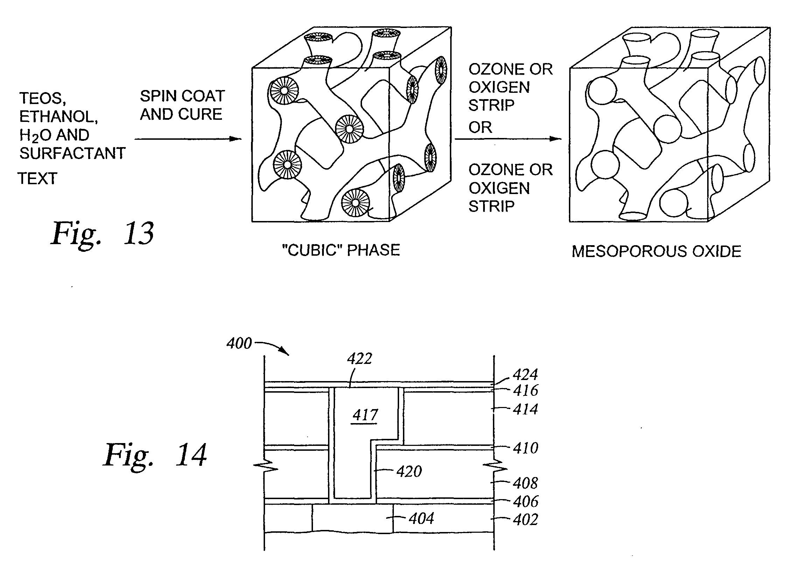

Figure 13 illustrates a process for forming a mesoporous oxide dielectric on a substrate. The process includes depositing a sol gel precursor solution containing a surfactant on a substrate, curing the deposited sol gel to form an oxide film, and exposing the film to an oxidizing environment, such as an ozone plasma, to remove the surfactant and form a mesoporous dielectric film. Materials may be substituted in several of the process steps to achieve various effects, and processing parameters such as times, temperatures, pressures, and relative concentrations of materials may be varied over broad ranges. In any case, another method which produces a similar porous dielectric layer could be substituted for the described method.

The process begins in the high pressure deposition module by the formation of a sol gel precursor. Sol gel precursors are typically formed by the mixture of a silicon/oxygen compound, water, and a surfactant in an organic solvent. Any conventional method known in the art may be used to form a sol gel precursor, but a exemplary sol gel precursor of the invention may be formed by a mixture of tetraethylorthosilicate (TEOS), ethanol, water, and a surfactant. An optional acid or base catalyst may be further used in the formation of the sol gel precursor.

The sol gel precursor is then applied to the substrate by either a spin-on coating or spray-coating method, but preferably by a spin-on coating deposition process. During spin-on coating, centrifugal draining allows the film to substantially cover the substrate in a thin layer of sol gel precursor. The sol gel precursor on the substrate is then subjected to a curing process to remove solvent and water from the sol gel to form interconnecting pores of uniform diameter, preferably in a cubic phase structured film. Next, the film is exposed to an oxidizing environment wherein the surfactant is removed from the film and is transformed into a mesoporous oxide film.

The silicon/oxygen compound of the sol gel precursor are those conventionally used in the deposition of silicon containing layers in semiconductor manufacturing, wherein silica sols are most preferably used. The silicon/oxygen precursor compound tetraethoxysilane (TEOS), phenyltriethyloxy silane, methyltriethoxy silane are preferably used, [however, any commercially available or conventionally used sol gel silicon/oxygen compound, such as tetramethoxysilane (TMOS) may be used with the invention.

Surfactants are used in sol gel precursors to ensure effective dispersion of the silicon/oxygen compounds in the solution for even film content deposition on the substrate. Surfactants may be anionic, cationic, or non-ionic. Surfactants use bonding groups that are hydrophilic to ensure a thorough dispersion in a solvent containing water. Non-ionic surfactants have chemical bonding groups that are uncharged or neutral hydrophilic groups while anionic and cationic surfactants have bonding groups respectfully charged negatively and positively. For the formation of the interconnecting pores of uniform diameter, preferably in a cubic phase structure of the invention, a non-ionic surfactant is used and is preferably selected from the group of primary amines, polyoxyethylene oxides-propylene oxide-polyethylene oxide triblock copolymers, octaethylene glycol monodecyl ether, octaethylene glycol monohexadecyl ether, and combinations thereof.

An organic solvent is used in the solution to help provide for silicon/oxygen compound dispersion in the sol gel and for ease in spraying or depositing the sol gel on the substrate in the spinner chamber. The present invention uses organic solvents, preferably alcohols, selected from the group of ethanol, n-propanol, iso-propanol, n-butanol, sec-butanol, tert-butanol, ethylene glycol, or combinations thereof. The organic solvent in the deposited sol gel is typically removed by a curing process that may comprises one or more steps between about 50°C and about 450°C. The curing process is preferably performed for about one minutes to about ten minutes in a curing/baking chamber.

During the curing step, preferential evaporation of the organic solvent and some removal of the moisture in the film increases the concentration of non-volatile surfactant and silicon/oxygen compounds such as silica. As the surfactant concentration increases, the surfactant and the silicon/oxygen compound form molecular assemblies within the thinning film. Continued drying solidifies the film, entrenching the film microstructure which in the invention is a cubic phase structure of interconnecting pores of uniform diameter as shown in Figure 13.

The deposited film is exposed to an oxidizing atmosphere at an elevated temperature. The temperature of the oxidizing atmosphere is preferably in the range of about 200°C to about 400°C. The oxidizing environment preferably comprises a oxygen, ozone, or an oxygen plasma to form a reactive oxygen species, wherein most preferably, a ozone plasma is formed in the chamber. The plasma is performed at a pressure of between about 0.5 Torr and about 10 Torr. The oxygen species bombard the film and react with the surfactant and any remaining moisture and solvent, thereby removing those agents from the film. The ion species are highly reactive and only require a short exposure of about 0.5 minutes to about 5 minutes for removal of the surfactant. As the surfactants are removed from the film, pores are formed as the silicon/oxygen component of the assemblies retain the shape of the oxide film, preferably a cubic phase structure, and harden to form a mesoporous film. The pores are usually have an interconnected structure, but many have terminal branches or may form amorphous layers. The selective formation of the mesoporous films result in a highly porous film of greater than 50% air with an exhibited dielectric constant of less than 2.5, preferably between about 2.2 and 1.6.

Alternatively, the mesoporous oxide film can be formed by removing the surfactant in a high temperature anneal of about 400°C to about 450°C. The annealing process may be performed at pressures ranging from near vacuum to atmospheric. Preferably, the annealing step is performed at a similar pressure to the pressure of the deposition module, i.e. greater than about 300 Torr. More preferably, the annealing process is performed at a pressure between about 300 Torr and about 700 Torr, most preferably between about 500 Torr and about 700 Torr. However, the annealing step may be performed at near vacuum pressures similar the oxidizing plasma process at a pressure of about 10 Torr or less. The film is annealed in a non-reactive atmosphere, where the non-reactive gases are preferably nitrogen, an inert gas, such as argon and helium, or combinations thereof. The oxide film is preferably annealed when the precursor compounds comprise methyl or phenyl groups, such as in phenyltriethyloxy silane and methyltriethoxy silane. Annealing of the film deposited from the methyl or phenyl containing precursor compound prevents oxidation and removal the of methyl and phenyl compounds. With the retained methyl and phenyl groups, the film has a higher carbon content, which is believed to provide for a lower dielectric constant film. The annealing step likewise produces highly porous film of greater than 50% air with an exhibited dielectric constant of less than 2.5, preferably from about 2.2 to about 1.6.

Mesoporous oxide films are highly hydrophilic and sensitive to moisture contamination, wherein moisture (dielectric constant (k) > 78) contamination can have a detrimental effect on the film's overall dielectric constant. Therefore, the film is typically post treated by silylating the film and/or capping the film with a capping layer.

Silylation is the process of introducing silicon into the upper surface of a deposited film. In a chemical reaction, liquid phase or vapor phase diffusion of a reactive organosilane occurs in a reaction chamber, causing the hydrogen of hydroxyl groups present on the upper surface of the film to be replaced with an organo-silicon group, most commonly a trimethyl silyl group. An example of such a chemical reaction is the introduction of hexamethyldisilazane (HMDS) over a dielectric layer on the substrate to form a silyl ether. The silylation process is accomplished by diffusing a silylating agent at a temperature between about 25°C to about 200°C, which affects the exposed mesoporous oxide film to make the exposed film hydrophobic. The preferred silylating agents in this invention are tetramethyl disilazane (TMDS), hexamethyl disilazane (HMDS), and dimethylaminotrimethyl silane, or combinations thereof.

A capping layer deposited on the mesoporous oxide layer may be any material which provides a barrier from diffusion of such materials as moisture, which serves as an etch stop, or which serves as a hard mask. Preferably, the capping layer is an low dielectric film deposited by a plasma enhanced chemical vapor deposition (PECVD) chamber at chamber pressures of about 0.5 Torr to about 10 Torr. Examples of suitable materials are silicon dioxide, silicon nitride, silicon oxynitride, and amorphous silicon carbide. An exemplary material to use as a liner layer is an amorphous silicon carbide layer, BLOk™, which is described in U.S. Patent Application Serial No, 09/165,248, entitled, "A Silicon Carbide Deposition For Use As A Barrier Layer And An Etch Stop", Filed on October 1, 1998, and incorporated herein.

### Deposition of a Dual Damascene Structure

A dual damascene structure which includes a mesoporous oxide layer with amorphous silicon carbide etch stops is shown in Figure 14. The mesoporous oxide 408 is deposited on a substrate 402 as described above, the substrate having patterned conducting lines 404 formed therein with a substrate etch stop 406 of silicon nitride or amorphous silicon carbide, preferably BLOk™, deposited thereon, and then a first etch stop 410 is deposited on the mesoporous oxide 408, the first etch stop 410 preferably being BLOk™. The first etch stop 410 is then pattern etched to define the openings of the contacts/vias 415. A second dielectric layer 414 which may be a mesoporous oxide layer, is then deposited over the patterned first etch stop 410, and then a second etch stop 416, the second etch stop preferably being BLOk™ before being pattern etched by conventional methods to define the interconnect lines 417. A single etch process is then performed to define the interconnects down to the patterned lines 404 and to etch the unprotected dielectric exposed by the patterned etch stop to define the contacts/vias 415. Once etched, a liner layer 420 and subsequent conducting metal 422 are deposited to fill the interconnect 417. The interconnect can then be planarized and capped with a silicon nitride or BLOk™ layer 424.

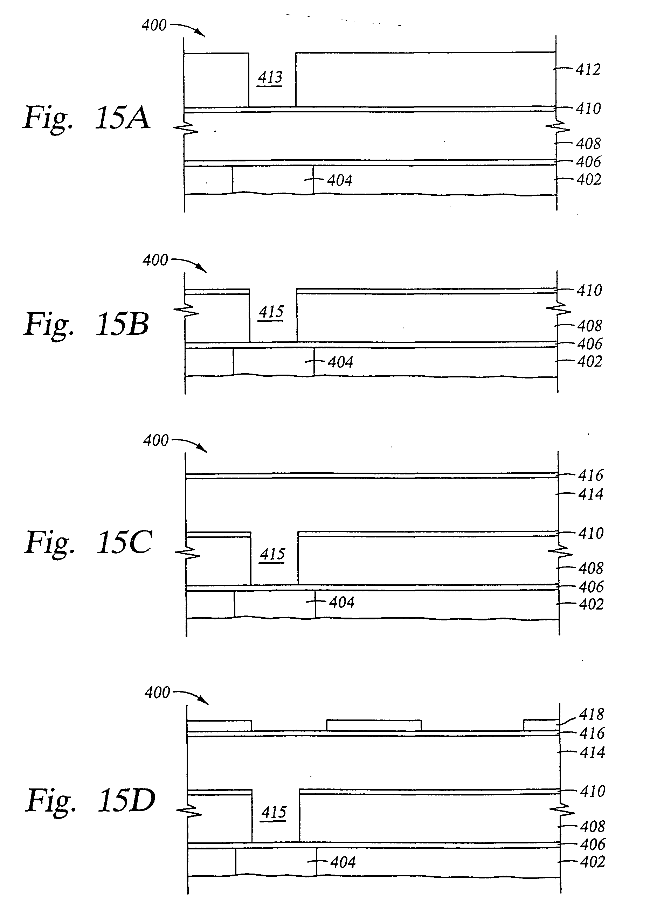

A preferred dual damascene structure fabricated in accordance with the invention is shown in Fig. 14, and the method of making the structure is sequentially depicted schematically in Figures 15A-15H, which are cross sectional views of a substrate having the steps of the invention formed thereon. As shown in Fig. 15A, an initial oxide or first mesoporous oxide dielectric layer 408 is deposited on the amorphous silicon carbide BLOk™ substrate etch stop 406 disposed conformally on the substrate 402 as described herein to a thickness of about 5,000 to about 10,000 Å, depending on the size of the structure to be fabricated. As shown in Fig. 15A, a low k etch stop 410, which is preferably a BLOk™ layer, is then deposited on the first dielectric layer 408 in a capping module to a thickness of about 200 to about 1000 Å. A photoresist layer 412 is then formed on the etch stop 410 by any conventional means known in the art with an opening 413 formed therein. The low k etch stop 410 and dielectric layer 408 are then pattern etched to define the contact/via openings 415 and to expose first dielectric layer 410 and substrate etch stop 406 in the areas where the contacts/vias are to be formed as shown in Fig. 15B. Preferably, the low k etch stop 410 is pattern etched using conventional photolithography and etch processes using fluorine, carbon, and oxygen ions.

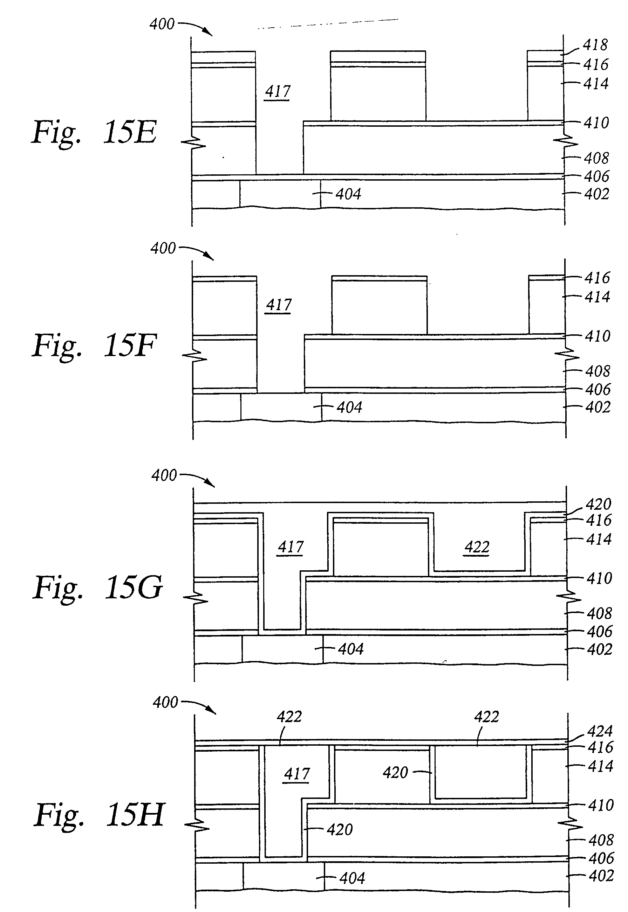

After low ketch stop 410 has been etched to pattern the contacts/vias and the photo resist has been removed as shown in Fig. 15B, a second mesoporous oxide dielectric layer 414 is deposited over etch stop 410 to a thickness of about 5,000 to about 10,000Å as shown in Fig. 12C. A second etch stop 416, preferably of BLOk™ deposited in a capping module as shown in Fig. 15C, and a photo resist layer 418 are deposited on the second mesoporous oxide dielectric layer 414, prior to being patterned to define interconnect lines 417, preferably using conventional photolithography processes, such as trench lithography, as shown in Fig. 15D. The interconnects and contacts/vias are then etched using reactive ion etching or other anisotropic etching techniques to define the metallization structure (*i*.*e*., the interconnect and contact/via) as shown in Figure 15E. Any photo resist to pattern the second etch stop 416 or the second dielectric layer 414 is removed using an oxygen strip, inert anneal, or other suitable process. The substrate etch stop 406 is similarly stripped to provide for contact between the patterned lines 404 and any subsequent material depositions as shown in Fig. 15F.

The metallization structure is then formed with a conductive material such as aluminum, copper, tungsten or combinations thereof. Presently, the trend is to use copper to form the smaller features due to the low resistivity of copper (1.7 mW-cm compared to 3.1 mW-cm for aluminum). Preferably, as shown in Fig. 15G, a suitable barrier layer 420 such as tantalum, tantalum nitride, or tungsten nitride, but preferably tantalum nitride, is first deposited conformally in the metallization pattern to prevent copper migration into the surrounding silicon and/or dielectric material. Thereafter, copper 422 is deposited using either chemical vapor deposition, physical vapor deposition, electroplating, or combinations thereof to form the conductive structure. A seed layer (not shown), preferably of copper or doper copper, may be deposited prior to the deposition of the copper fill 422 to ensure a voidless fill of the interconnect 417. Once the structure has been filled with copper or other metal, the surface is planarized using chemical mechanical polishing, and capped with a silicon nitride or amorphous silicon carbide BLOk™ layer 424 as shown in Fig. 15H.

## Claims

1. An apparatus for processing substrates, comprising:
(a) one or more transfer chambers;
(b) a substrate handling member disposed in each of the one or more transfer chambers;
(c) one or more processing chambers, each processing chamber defining at least one isolated processing region therein, wherein each processing region is connected to the one or more transfer chambers;
(d) one or more loadlock chambers in communication with the one or more transfer chambers; and
(e) one or more multi-slot substrate pre-heating modules in communication with the one or more transfer chambers.

2. The apparatus of claim 1, wherein a remote plasma system is in fluid communication with each processing region.

3. The apparatus of claim 1, further comprising a high pressure deposition module connected to the one or more load lock chambers.

4. The apparatus of claim 3, wherein the high pressure deposition module is a spin-on dielectric module comprising one or more substrate stripping chambers.

5. An apparatus for processing substrates, comprising:
(a) a high pressure deposition module;
(b) a first transfer chamber in communication with the high pressure deposition module;
(c) a loadlock chamber in communication with the first transfer chamber;
(d) a second transfer chamber in communication with the loadlock chamber;
(e) a multi-slot substrate pre-heating module in communication with the first transfer chamber;
(f) a substrate handling member disposed in the second transfer chamber; and
(g) one or more processing chambers, each processing chamber defining at least one isolated processing region therein, wherein each processing region is connected to the second transfer chamber.

6. The apparatus of claim 5, wherein the high pressure deposition module comprises:
(a) one or more substrate spinner chambers;
(b) one or more substrate curing chambers;
(c) one or more substrate stripping chambers;
(d) one or more silylation deposition chambers; and
(e) a second substrate handling member disposed in the high pressure deposition module.

7. The apparatus of any of the preceding claims, further comprising one or more multi-slot cooling stations disposed within each of the one or more loadlock chambers.

8. The apparatus of any of the preceding claims, wherein each processing chamber has two isolated processing regions.

9. The apparatus of any of the preceding claims, wherein each processing region includes a gas distribution assembly disposed therein and each gas distribution assembly shares process gases from one or more gas sources.

10. The apparatus of any of the preceding claims, wherein the one or more multi-slot pre-heating modules is/are disposed within the loadlock chamber.

11. A process for forming a mesoporous oxide film on a substrate, comprising:
a) forming a sol gel precursor comprising a silicon/oxygen compound, an organic solvent, water, and a surfactant;
b) depositing the sol gel precursor on the substrate;
c) curing the deposited sol gel precursor to form an oxide film; and
d) exposing the film to an oxidizing environment to form a mesoporous oxide film.

12. The process of claim 11, wherein the oxidizing environment comprises a reactive oxygen species.

13. A process for forming a mesoporous oxide film on a substrate, comprising:
a) introducing a substrate into a chamber;
b) depositing a sol gel precursor on the substrate to form an oxide film, the sol gel precursor comprising a silicon/oxygen compound, an organic solvent, water, and a surfactant; and
c) removing the organic solvent, water, and the surfactant from the oxide film by heating the film at a temperature of about 200°C to about 450°C in an inert atmosphere to form a mesoporous oxide film.

14. The process of claim 11 or 13, further comprising adding an acid or base catalyst to the sol gel precursor prior to deposition of the sol gel precursor.

15. The process of claim 13, wherein the atmosphere comprises an oxidizing environment of reactive oxygen species.

16. The process of claim 11 or 13, further comprising silylating the mesoporous oxide to render the film hydrophobic.

17. The process of claim 11 or 13, further comprising depositing a capping layer on the mesoporous oxide film.

18. A computer storage medium containing a software routine that, when executed, causes a general purpose computer to control a deposition chamber using a method of any of the claims 11 to 17.
